(19) Europäisches Patentamt / European Patent Office / Office européen des brevets

(11) **EP 3 982 428 B1**

(12) **EUROPEAN PATENT SPECIFICATION**

(45) Date of publication and mention of the grant of the patent:
**27.12.2023 Bulletin 2023/52**

(21) Application number: **20819278.1**

(22) Date of filing: **02.06.2020**

(51) International Patent Classification (IPC):
*H01L 33/50* $^{(2010.01)}$    *F21S 8/00* $^{(2006.01)}$
*F21Y 115/10* $^{(2016.01)}$    *F21Y 103/10* $^{(2016.01)}$

(52) Cooperative Patent Classification (CPC):
**H01L 33/504; F21S 8/00;** F21Y 2103/10;
F21Y 2115/10; H01L 33/501; H01L 2933/0091

(86) International application number:
**PCT/CN2020/093967**

(87) International publication number:
**WO 2020/244512 (10.12.2020 Gazette 2020/50)**

(54) **WHITE LIGHT SOURCE MODULE AND LIGHTING DEVICE COMPRISING THE SAME**

WEISSLICHTQUELLENMODUL UND BELEUCHTUNGSVORRICHTUNG MIT DEM GLEICHEN

MODULE DE SOURCE DE LUMIÈRE BLANCHE ET DISPOSITIF D'ÉCLAIRAGE LE COMPRENANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **05.06.2019 CN 201910486921**
**05.06.2019 CN 201920842848 U**

(43) Date of publication of application:
**13.04.2022 Bulletin 2022/15**

(73) Proprietors:
• **Suzhou Opple Lighting Co., Ltd.**
**Suzhou, Jiangsu 215211 (CN)**
• **Opple Lighting Co., Ltd.**
**Shanghai 201201 (CN)**

(72) Inventors:
• **ZHOU, Zhixian**
**Suzhou, Jiangsu 215211 (CN)**
• **QIANG, Jie**
**Suzhou, Jiangsu 215211 (CN)**

(74) Representative: **dompatent von Kreisler Selting Werner -**
**Partnerschaft von Patent- und Rechtsanwälten mbB**
**Deichmannhaus am Dom**
**Bahnhofsvorplatz 1**
**50667 Köln (DE)**

(56) References cited:
**DE-A1-102014 117 771**    **US-A1- 2019 058 092**
**US-A1- 2019 103 522**

**Description**

TECHNICAL FIELD

The present invention relates to a light source module and a lighting device comprising the light source module.

BACKGROUND

With the arrival and development of the third lighting technology revolution, incandescent lamps and halogen lamps, etc. have been gradually banned from production and sales all over the world due to low luminous efficiency and non-energy saving, and LED lighting appliances have been widely used instead. Existing LED lighting products mainly solve the problems of energy saving, illumination, color and color rendering. In the case of using the LED lighting products, more and more people are concerned that lighting may affect the physiological rhythm of human body. For the impact of lighting products on human physiological rhythm, we can evaluate it through the circadian stimulus evaluation model, that is, the CS value in the industry, the spectrum with high CS value is especially suitable for people to concentrate on study and work under the same illumination. At present, the lamps used in office buildings usually only consider the indicators such as color temperature and illumination, and there is no LED lighting product that can improve students' concentration by increasing the CS value, and can take into account energy saving, illumination, color and color rendering. DE 10 2014 117771 A1 discloses an illumination light source including a solid-state light-emitting element and a wavelength converter, wherein a correlated color temperature of composite light is in a range of 5700K to 7100K. A spectral distribution of the composite light has a first peak or maximum wavelength in a range from 430 nm to 470 nm, a second peak or maximum wavelength in a range from 490 nm to 540 nm, a third peak or maximum wavelength in a range from 600 nm to 640 nm, a first minimum value of the intensity between the first peak wavelength and the second peak wavelength and a second minimum value between the second peak wavelength and the third peak wavelength. A difference between a second peak or maximum value and the first minimum value is in a range of 30% to 55% with respect to the second peak value. A difference between the second peak value and the second minimum value is in a range of 20% to 45% with respect to the second peak value.
US 2019/0058092 A1 discloses a light-emitting device including a mount board, an LED element mounted on the mount board, and a translucent or transparent sealing resin being filled onto the mount board to seal the LED element. The sealing resin contains first and second particulate phosphors excited by emitted light from the LED element, and a nanoscale filler having an average particle size in the range of 1 nm to 100 nm. The specific gravity of the first particulate phosphor is smaller than that of the second particulate phosphor. The sealing resin includes a dispersion layer of the first particulate phosphor covering areas obliquely above and beside the LED element, and a deposition layer of the second particulate phosphor on upper surfaces of the mount board and the LED element. The first particulate phosphor is dispersed in the dispersion layer among aggregates formed by particles of the nanoscale filler.
US 2019/0103522 A1 discloses a lighting apparatus including an LED chip that emits primary light, and phosphor particles that emit secondary light by being excited with the primary light. The lighting apparatus emits light including the primary light and the secondary light. The light has an emission spectrum having a first peak in a wavelength ranging from 420 nm to 460 nm, a second peak in the wavelength ranging from 530 nm to 580 nm, a third peak in the wavelength ranging from 605 nm to 655 nm, a first trough in the wavelength ranging from 440 nm to 480 nm, and a second trough in the wavelength ranging from 555 nm to 605 nm.

SUMMARY

The purpose of the present invention is to solve the above problems and find a cold white LED (5700K) light source with high CS values, high color rendering and high luminous efficiency.
The present invention is defined by the appended claims. Preferred embodiments are included as dependent claims. In order to realize the above functions, the technical scheme adopted by the present invention is to provide a light source module in accordance with the appended claim 1, which comprises a first light-emitting element and a packaging part covering the first light-emitting element. The first light-emitting element emits first color light with a peak wavelength of 435 ~ 465nm; the packaging part comprises: a first additional luminous body which is arranged to receive part of the light emitted by the first light-emitting element and convert it into second color light with a peak wavelength of 485 ~ 515nm; the second additional luminous body which is arranged to receive part of the light emitted by the first light-emitting element and convert it into third color light with a peak wavelength of 520 ~ 580nm; the third additional luminous body which is arranged to receive part of the light emitted by the first light-emitting element and convert it into fourth color light with a peak wavelength of 615 ~ 655nm, the first color light, the second color light, the third color light and the fourth color light are mixed to form emitted light of the light source module, and the emitted light is cold white light, that is, on a CIE1931 color space, the emitted light is located in an interval enclosed by points with correlated color temperature of 5750±400K and distances from the black body trajectory duv=-0.006-0.006. The spectrum of the emitted light has following features achieved by selecting the appropriate powder weight ratio: defining a spectrum of the emitted light is in a visible light range, that is, a wavelength range [380 - 780nm], as an entire spectral energy of the emitted light; a spectral energy in the wavelength range [380 - 470nm] accounts for 12.0% ~ 32.0% of the entire spectral energy; a spectral energy in the wavelength range [470 ~ 560nm] accounts for 25.0% ~ 45.0% of the entire spectral energy; a spectral energy in the wavelength range [560 ~ 780nm] accounts for 36.0% ~ 56.0% of the entire spectral energy; a spectral energy in the wavelength range [470 ~ 520nm] accounts for 14.0% ~ 34.0% of the entire spectral energy.

Preferably, in the spectrum of the emitted light: the spectral energy in the wavelength range [380 - 470nm] accounts for 17.0% - 27.0% of the total spectral energy; the spectral energy in the wavelength range [470 ~ 560nm] accounts for 27.0% - 37.0% of the total spectral energy; the spectral energy in the wavelength range [560 ~ 780nm] accounts for 40.0% - 50.0% of the total spectral energy; and the spectral energy in the wavelength range [470 ~ 520nm] accounts for 18.0% - 28.0% of the total spectral energy.

Preferably, the spectrum of the emitted light is continuously distributed in the visible light range of 380 ~ 780nm, and comprises three peaks and two peak valleys, a first peak is located in a wavelength range of 435 ~ 465 nm ; the second peak is located in a wavelength range of 485 ~ 525nm, and a ratio of a spectral intensity of the second peak to the spectral intensity of the first peak ranges from 45.0% to 85.0%; a first peak valley is located between the first peak and the second peak, and a ratio of a spectral intensity of the first peak valley to the spectral intensity of the first peak is greater than or equal to 25.0%; a third peak is located in a wavelength range of 595 ~ 645nm, and a ratio of a spectral intensity of the third peak to the spectral intensity of the first peak ranges from 40.0% to 70.0%; and a second peak valley is located between the second peak and the third peak, and a ratio of a spectral intensity of the second peak valley to the spectral intensity of the first peak ranges from 30.0% to 60.0%.

Preferably, in the spectrum of the emitted light: the ratio of the spectral intensity of the second peak to the spectral intensity of the first peak ranges from 55.0% to 75.0%; the ratio of the spectral intensity of the third peak to the spectral intensity of the first peak ranges from 42.0% to 60.0%; and the ratio of the spectral intensity of the second peak valley to the spectral intensity of the first peak ranges from 35.0% to 50.0%.

Preferably, in the spectrum of the emitted light: the ratio of the spectral intensity of the third peak to the spectral intensity of the second peak ranges from 75% to 105%.

Preferably, in the spectrum of the emitted light: the ratio of the spectral intensity of the third peak to the spectral intensity of the second peak ranges from 80% to 100%.

According to the present invention, the first light-emitting element is a blue LED emitting light with a peak wavelength of 435 ~ 465nm; the first additional luminous body is blue-green fluorescent powder with a peak wavelength of 485 ~ 515nm and a half width of 25 ~ 65nm; the second additional luminous body is yellow fluorescent powder and/or green fluorescent powder with a peak wavelength of 520 ~ 580nm and a half width of 60 ~ 115nm; the third additional luminous body is red fluorescent powder or orange fluorescent powder with a peak wavelength of 615 ~ 655nm and a half width of 80 ~ 120nm, and defining a total weight of the first additional luminous body, the second additional luminous body and the third additional luminous body to be a total fluorescent powder weight.

According to the present invention, a ratio of the first additional luminous body in the total fluorescent powder weight ranges from 20.0 to 55.0%.

According to the present invention, a ratio of the second additional luminous body in the total fluorescent powder weight ranges from 22.0% to 52.0%.

According to the present invention, a ratio of the third additional luminous body in the total fluorescent powder weight ranges from 7.0% to 36.0%.

Preferably, the blue-green fluorescent powder is formed by mixing any one or more of following fluorescent powder: (a) nitrogen oxide with $Eu^{2+}$ as an activator, and general chemical composition formula: $(Ba,Ca)_{1-x}Si_2N_2O_2:Eu_x$, where x = 0.005 ~ 0.200; (b) Ga doped garnet fluorescent powder with $Eu^{2+}$ as an activator, and general chemical composition formula: Ga-LuAG:Eu; (c) silicate fluorescent powder with $Eu^{2+}$ as an activator, and general chemical composition formula: $Ba_2SiO_4:Eu$.

Preferably, the yellow fluorescent powder/green fluorescent powder is formed by mixing any one or more of following fluorescent powder: (a) garnet structure fluorescent powder with $Ce^{3+}$ as an activator, and general chemical composition formula: $(M1)_{3-x}(M2)_5O_{12}:Ce_x$, where M1 is at least one element selected from a group consisting of Y, Lu, Gd and La, M2 is at least one element selected from a group consisting of Al and Ga, and x = 0.005 ~ 0.200; (b) silicate system fluorescent powder with $Eu^{2+}$ as an activator, and general chemical composition formula: $(M3)_{2-x}SiO_4:Eu_x$ or $(Ba,Ca,Sr)_{2-x}(Mg,Zn)Si_2O_7:Eu_x$, where M3 is at least one element selected from a group consisting of Mg, Sr, Ca and Ba, and x = 0.01 ~ 0.20; (c) nitrogen oxide fluorescent powder (Cylon β - SiALON) with $Eu^{2+}$ as an activator, and general chemical composition formula: $Si_bAl_cO_dN_e:Eu_x$, where x = 0.005 ~ 0.400, b + c = 12, and d + e = 16; (d) aluminate system fluorescent powder with $Eu^{2+}$ as an activator, and general chemical composition formula: $(Sr,Ba)_{2-x}Al_2O_4:Eu_x$ or $(Sr,Ba)_{4-x}Al_{14}O_{25}:Eu_x$, where x = 0.01 ~ 0.15.

Preferably, the red fluorescent powder or the orange fluorescent powder is formed by mixing any one or more of following fluorescent powder: (a) nitride red powder having a 1113 crystal structure with $Eu^{2+}$ as an activator, and general chemical composition formula: $(M4)_{1-x}AlSiN_3:Eu_x r$, where M4 is at least one element selected from a group consisting of Ca, Sr and Ba, x = 0.005 ~ 0.300; (b) nitride red powder having a 258 crystal structure with $Eu^{2+}$ as an activator, and general chemical composition formula: $(M5)_{2-x}Si_5N_8:Eu_x$, where M5 is at least one element selected from a group consisting of Ca, Sr, Ba and Mg, x = 0.005 ~ 0.300; (c) nitrogen oxide fluorescent powder (Cylon $\alpha$ - SiALON) with $Eu^{2+}$ as an activator, and general chemical composition formula: $((M6)_{1-a})_x Si_b Al_c O_d N_e:Eu_a$, where M6 is at least one element selected from a group consisting of Li, Na, K, Rb, Cs, Sr, Ba, Sc, Y, La and Gd, x = 0.15 ~ 1.5, a = 0.005 ~ 0.300, b + c = 12, and d + e = 16; (d) silicate fluorescent powder with $Eu^{2+}$ as an activator, and general chemical composition formula: $(Sr,Ba)_{3-x}Si_5O_5:Eu_x$.

Preferably, the packaging part further comprises a base material and a light diffuser, the base material is silica gel or resin, and the light diffuser is one selected from a group consisting of nano titanium oxide, nano alumina and nano silicon oxide.

Preferably, on the CIE1931 color space, light color of the emitted light of the light source module is located in a quadrilateral region enclosed by four vertices D1 (0.3184,0.3401), D2 (0.3203,0.3189), D3 (0.3356,0.3323) and D4 (0.3364,0.3564).

Preferably, on the CIE1931 color space, the light color of the emitted light of the light source module is located within an elliptical range with a center point x0 = 0.3281, y0 = 0.3372, a long axis a = 0.00223, a short axis b = 0.00095, an inclination angle $\theta$= 58.2 °, and an SDCM = 5.0.

Preferably, in a case that the emitted light of the light source module has an illuminance of 500lux, a CS value is $\geq$ 0.45.

Preferably, a color rendering index CRI of the emitted light of the light source module is $\geq$ 90.0.

The present invention further provides a lighting device in accordance with the appended claim 15, which comprises the above light source module.

The light source module provided by the present invention provides a cold white LED (5700K) light source with high luminous efficiency, high CS values and high color rendering by controlling the ratio of luminous energy of emitted light in different wavelength ranges. This kind of spectrum with high CS values is conducive to people's concentration for study and work under the same illumination and is especially suitable for office lighting.

BRIEF DESCRIPTION OF THE DRAWINGS

FIG. 1 is a structural diagram of a light source module according to an embodiment of the present invention;
FIG. 2 is a schematic diagram of spectral features of a light source module according to an embodiment of the present invention;
FIG. 3 is a CIE1931 color coordinate diagram according to embodiment 1 to embodiment 8 of the present invention;
FIG. 4 is a spectrum diagram of emitted light according to embodiment 1 of the present invention;
FIG. 5 is a spectrum diagram of emitted light according to embodiment 2 of the present invention;
FIG. 6 is a spectrum diagram of emitted light according to embodiment 3 of the present invention;
FIG. 7 is a spectrum diagram of emitted light according to embodiment 4 of the present invention;
FIG. 8 is a spectrum diagram of emitted light according to embodiment 5 of the present invention;
FIG. 9 is a spectrum diagram of emitted light according to embodiment 6 of the present invention;
FIG. 10 is a spectrum diagram of emitted light according to embodiment 7 of the present invention;
FIG. 11 is a spectrum diagram of emitted light according to embodiment 8 of the present invention; and
FIG. 12 is a structural diagram of a lamp according to an embodiment of the present invention.

DETAILED DESCRIPTION

A light source module and a lighting device proposed by the present invention are described in further detail below in combination with accompanying drawings and some embodiments in accordance with the present invention.

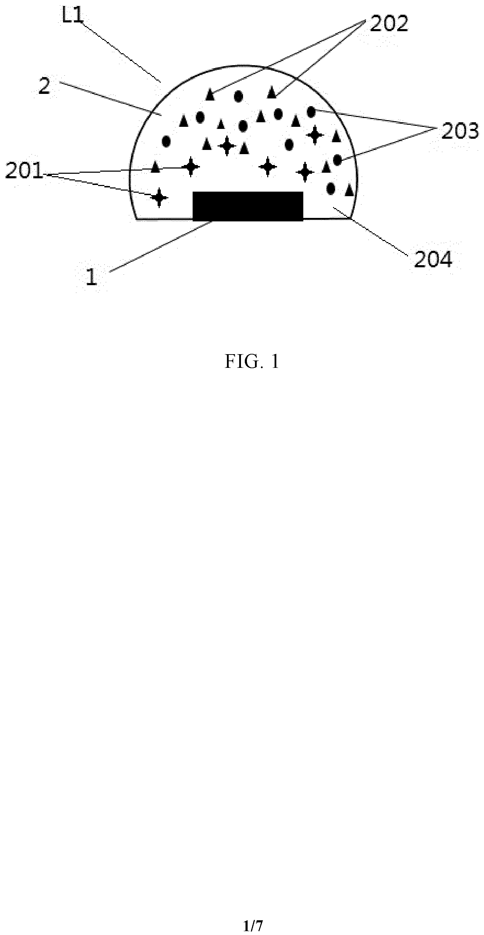

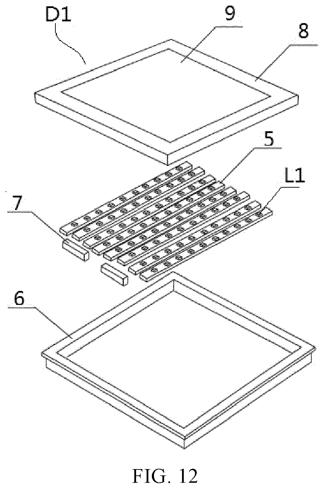

As shown in FIG. 1, the light source module L1 in an embodiment provided by the present invention is a light source product, which can be applied to a lighting device D1 as shown in FIG. 12 to provide classroom lighting. The lighting device D1 is a lamp panel, which may also be a chandelier, a ceiling lamp, etc. in other preferred embodiments, or the light source module L1 may also be applied to various lamps such as table lamp, down light, spotlight, etc. The lighting device D1 comprises a chassis 6, a face frame 8 provided with a diffusion plate 9, a light source module L1 arranged on the light source plate 5 and a power supply module 7 providing power required for the work of the light source module L1. The lighting device D1 may also be provided with a controller, a heat dissipation device, and a light distribution component, etc. according to the functions and requirements of specific lamps. The controller can be used to adjust the light color, light intensity, etc. of the irradiated light emitted by the light source module L1, and the light distribution component may also be a lampshade, a lens, a diffusion element, a light guide, etc. in addition to the diffusion plate in the embodiment.

A specific embodiment of the light source module L1 of the present invention is a light-mixing white light LED packaging chip, which may be an LED chip with a general patch packaging structure or COB packaging structure. As shown in FIG. 1, the light source module L1 comprises at least one first light-emitting element 1 and a packaging part 2 covering the first light-emitting element.

The first light-emitting element 1 is a blue LED chip, which is directly excited by semiconductor materials, its peak wavelength of the light emission is located in the range of 435 ~ 465nm, and the light color is blue. Here, we call the light emitted by the first light-emitting element 1 as the first color light. LED chip comprises front-mounted chip or flip-chip, single LED chip or multiple LED chips are connected together in series, parallel or series parallel.

The packaging part 2 uses transparent silica gel or transparent resin as a base material 204, and the transparent resin refers to one of epoxy resin and urea resin. The base material 204 is doped with a first additional luminous body 201, a second additional luminous body 202 and a third additional luminous body 203. The first additional luminous body 201 is blue-green fluorescent powder that receives part of the light emitted by the first light-emitting element 1 and converts it into the second color light with a peak wavelength of 485 ~ 515nm and a half width of 25 ~ 65nm. The second additional luminous body 202 comprises at least one of yellow fluorescent powder and green fluorescent powder with a peak wavelength of 520 ~ 580nm, a half width of the emission spectrum of 60 ~ 115nm, and an optional half width of 90 ~ 115nm. Because color is an intuitive perception of human body, it is impossible to accurately distinguish the spectral boundaries between yellow and green. In the present application, we call green fluorescent powder with a peak wavelength of 520 ~ 540nm and yellow fluorescent powder with a peak wavelength of 540 ~ 580nm. In the present application, the second additional luminous body 202 may adopt one of the yellow fluorescent powder and the green fluorescent powder, as in embodiment 1 hereafter. In other embodiments, two kinds of green powder may be mixed, as in embodiment 2 and embodiment 4. However, in order to provide better color rendering, the second additional luminous body in embodiments 3, 5, 6, 7 and 8 adopts the scheme of yellow fluorescent powder and green fluorescent powder. That is, the second additional luminous body comprises a combination of the yellow fluorescent powder and the green fluorescent powder. The combined fluorescent powder receives part of the light emitted by the first light-emitting element 1 and converts it into the third color light with a peak wavelength of 520 ~ 580nm. The third additional luminous body 203 is the red fluorescent powder or orange fluorescent powder that receives part of the light emitted by the first light-emitting element 1 and converts it into the fourth color light with a peak wavelength of 615 ~ 655nm and a half width of 80 ~ 120nm, and the optional half width is 80 ~ 100nm. The packaging part 2 may also comprise a light diffuser, the light diffuser may be one of nano titanium oxide, nano alumina and nano silicon oxide. The above various fluorescent powder and light diffuser are weighed at the ratio and mixed into the base material 204, and then fully and evenly stirred in a mixer to make the fluorescent powder and light diffuser evenly distributed in the base material 204. After removing bubbles, the base material 204 mixed with fluorescent powder is covered over the blue LED chip as the first light-emitting element 1 by a dispensing machine to form the packaging part 2.

Hereafter, we will illustrate the various fluorescent powders we use. For convenience of description, we define the sum of the weight of the first additional luminous body, the second additional luminous body and the third additional luminous body as the total fluorescent powder weight. The ratio of the total fluorescent powder weight in the packaging part 2 is 20 ~ 45%. The weight of the packaging part 2 is the total weight of the base material 204 mixed with the fluorescent powder and light diffuser.

The blue-green fluorescent powder as the first additional luminous body 201 accounts for 20.0 ~ 55.0% of the total fluorescent powder weight, which may be selected from any one of the following fluorescent powders or may be formed by mixing two or more of the following fluorescent powders. The specific types of fluorescent powders are as follows (in the present invention, the molar ratio is represented by x): (a) nitrogen oxide with $Eu^{2+}$ as an activator and the general chemical composition formula: $(Ba,Ca)_{1-x}Si_2N_2O_2:Eu_x$, where x = 0.005 ~ 0.200; (b) Ga doped garnet fluorescent powder with $Eu^{2+}$ as an activator and the general chemical composition formula: Ga-LuAG:Eu; and (c) silicate fluorescent powder with $Eu^{2+}$ as an activator and the general chemical composition formula: $Ba_2SiO_4:Eu$.

In this embodiment, the combination of yellow fluorescent powder and green fluorescent powder as the second additional luminous body 202 accounts for 22.0 ~ 52.0% of the total fluorescent powder weight. As mentioned above, there is no clear boundary between yellow and green. Similarly, the yellow fluorescent powder and the green fluorescent powder do not have a clear boundary, they basically have the same chemical general formula, and the difference is only that the molar ratios of components are different. Except for embodiment 1, embodiments 2-8 of the present application adopt two kinds of fluorescent powders with different peak wavelengths in the 520 ~ 580nm band for combination. Further, in the embodiments 3, 5, 6, 7 and 8, the two kinds of fluorescent powders adopt different light colors, one of which is yellow fluorescent powder, we define that its peak wavelength is greater than 540nm, and the other is green fluorescent powder, and its peak wavelength is less than 540nm. In this embodiment, two kinds of yellow fluorescent powder and green fluorescent powder with different peak wavelengths are selected for combination, mainly to improve visual performance and make the entire spectrum smoother. In other preferred embodiments, only one kind of yellow fluorescent powder or green fluorescent powder is selected to achieve the same CS value, but the visual performance may be slightly worse than that in this embodiment. The specific yellow fluorescent powder/green fluorescent powder may be formed by mixing any one or more of the following fluorescent powders: (a) garnet structure fluorescent powder with $Ce^{3+}$ as an activator and the general chemical composition formula: $(M4)_{3-x}(M5)_5O_{12}:Ce_x$, where M4 is at least one element of Y, Lu, Gd and La, M5 is at least one element of Al and Ga, x = 0.005 ~ 0.200; (b) silicate system phosphor with $Eu^{2+}$ as an activator and the general chemical composition formula: $(M6)_{2-x}SiO_4:Eu_x$, or $(Ba,Ca,Sr)_{2-x}(Mg,Zn)Si_2O_7:Eu_x$, where M6 is at least one element of Mg, Sr, Ca and Ba, x = 0.01 ~ 0.20; (c) nitrogen oxide fluorescent powder (Cylon $\beta$-SiAlON) with $Eu^{2+}$ as an activator, and the general chemical composition formula: $Si_bAl_cO_dN_e:Eu_x$, where x = 0.005 ~ 0.400, b + c = 12, d + e = 16; and (d) aluminate system fluorescent powder with $Eu^{2+}$ as an activator and the general chemical composition formula: $(Sr,Ba)_{2-x}Al_2O_4:Eu_x$, or $(Sr,Ba)_{4-x}Al_{14}O_{25}:Eu_x$, where x = 0.01 ~ 0.15.

The red fluorescent powder or the orange fluorescent powder as the third additional luminous body 203 accounts for 7.0 ~ 36.0% of the total fluorescent powder weight, which may be selected from any one of the following fluorescent powders, or may be formed by mixing two or more of the following fluorescent powders. The specific kinds of fluorescent powders are as follows (in the present invention, the molar ratio is represented by x): (a) nitride red powder in a 1113 crystal structure with $Eu^{2+}$ as an activator and the general chemical composition formula: $(M1)_{1-x}AlSiN_3:Eu_x$, where M1 is at least one element of Ca, Sr and Ba, x = 0.005 ~ 0.300; (b) nitride red powder in a 258 crystal structure with $Eu^{2+}$ as an activator and the general chemical composition formula: $(M2)_{2-x}Si_5N_8:Eu_x$, where M2 is at least one element of Ca, Sr, Ba and Mg, x = 0.005 ~ 0.300; (c) nitrogen oxide fluorescent powder (Cylon $\alpha$-SiAlON) with $Eu^{2+}$ as an activator and the general chemical composition formula: $((M3)_{1-a})_xSi_bAl_cO_dN_e:Eua$, where M3 is at least one element of Li, Na, K, Rb, Cs, Sr, Ba, Sc, Y, La and Gd, x = 0.15 ~ 1.5, a = 0.005 ~ 0.300, b + c = 12, d + e = 16; and (d) silicate fluorescent powder with $Eu^{2+}$ as an activator and the general chemical composition formula: $(Sr,Ba)_{3-x}Si_5O_5:Eu_x$, where x = 0.005 ~ 0.300.

The above shows the types of the fluorescent powders that may be selected. In the present application, we provide 8 specific embodiments. In these embodiments, a total of 9 kinds of fluorescent powders are selected. The parameters and chemical formulas of each fluorescent powder selected in the embodiments are shown in the table below. For ease of description, we have defined a code for the fluorescent powder in Table 1, we will describe the fluorescent powder with the code in the subsequent embodiment descriptions, and the peak value and chemical formula of the fluorescent powder will not be described in detail in each embodiment.

Table 1

| No | Color | Code | x | y | Peak (nm) | Hw (nm) | Chemical formula |
|---|---|---|---|---|---|---|---|
| 1 | red fluorescent powder | R650 | 0.6692 | 0.3305 | 647.9 | 86.6 | $Ca_{1-x}AlSiN_3:Eu_x$ (x=0.01~0.10) |
| 2 | red fluorescent powder | R640 | 0.6453 | 0.3540 | 639.2 | 95.1 | |
| 3 | red fluorescent powder | R630 | 0.6377 | 0.3617 | 627.8 | 94.2 | |
| 4 | yellow fluorescent powder | Y550 | 0.4165 | 0.5423 | 545.5 | 115.8 | $(Y,Gd)_3-x(Ga,Al)_5O_{12}:Ce_x$ (x=0.008~0.10) |
| 5 | yellow fluorescent powder | Y565 | 0.4546 | 0.5161 | 560.7 | 121.7 | |
| 6 | green fluorescent powder 1 | G-Ga535 | 0.3564 | 0.5679 | 529.3 | 106.2 | $Y_{3-x}(Ga,Al)_5O_{12}:Ce_X$ (x=0.01~0.10) |
| 7 | green fluorescent powder 2 | G-L535 | 0.3780 | 0.5658 | 538.5 | 107.6 | $(Lu,Gd,La)_{3-x}Al_5O_{12}:Ce_x$ (x=0.005~0.15) |
| 8 | blue-green fluorescent powder 1 | BG490 | 0.0761 | 0.4539 | 495.4 | 31.6 | $Ba_{1-x}Si_2N_2O_2:Eu_x$ (x=0.008~0.18) |
| 9 | blue-green fluorescent powder 2 | BG500 | 0.0645 | 0.4675 | 500.0 | 38.1 | $(Lu,Gd,La)_{3-x}Al_5O_{12}:Ce_x$ (x=0.005~0.15) |

The parameters in the above table are for the types of fluorescent powder, x and y represent the coordinate value of the light color of the fluorescent powder on the CIE1931 color space, Peak represents the peak wavelength, and Hw represents the half width. The above values are the actual values of the fluorescent powder used in the embodiments and are not a limitation of the present invention. Because in actual production, due to the difference in purity and particle size of the fluorescent powder, the peak wavelength and half width of the fluorescent powder may be deviated slightly from the above data, and this deviation value will generally be controlled within ± 5nm. It should be considered that other schemes within this range are equivalent to the above fluorescent powder.

Table 2 shows the eight embodiments of the present application, and the types of fluorescent powders and the weight of various types of fluorescent powders used in each embodiment. The ratio of each additional luminous body refers to the ratio of the weight of multiple fluorescent powders in each additional luminous body in the total fluorescent powder weight, respectively. The ratio of total fluorescent powder refers to the ratio of the total fluorescent powder weight, which refers to the weight of all fluorescent powders comprised in the three additional luminous body, in the total weight of the packaging part 2 after all the fluorescent powders are mixed with the base material 204. In these embodiments, the base material 204 is transparent silica gel with a weight of 10g.

Table 2

| | The first additional luminous body | | | The second additional luminous body | | | The third additional luminous body | | | The total fluore scent powd er ratio |
|---|---|---|---|---|---|---|---|---|---|---|
| | Code | Weight (g) | Ratio | Code | Weight (g) | Ratio | Code | Weight (g) | Ratio | |
| Embo diment 1 | BG500 | 1.63 | 33.3 % | Y565 | 1.95 | 39.9 % | R640 | 0.70 | 26.8% | 32.8% |
| | | | | | | | R630 | 0.61 | | |
| Embo diment 2 | BG490 | 1.40 | 27.7 % | G-Si525 | 0.90 | 43.5 % | R630 | 1.46 | 28.9% | 33.6% |
| | | | | G-Ga535 | 1.30 | | | | | |
| Embo diment 3 | BG490 | 1.35 | 26.2 % | Y565 | 1.00 | 45.9 % | R630 | 1.44 | 27.9% | 34.0% |
| | | | | G-Ga535 | 1.37 | | | | | |
| Embo diment 4 | BG490 | 1.32 | 29.4 % | G-L535 | 0.80 | 43.4 % | R630 | 1.22 | 27.2% | 31.0% |
| | | | | G-Ga535 | 1.15 | | | | | |
| Embo diment 5 | BG490 | 1.23 | 30.4 % | Y550 | 0.80 | 43.3 % | R630 | 1.06 | 26.2% | 28.8% |
| | | | | G-L535 | 0.95 | | | | | |
| Embo diment 6 | BG500 | 1.26 | 26.1 % | Y565 | 0.80 | 46.6 % | R630 | 1.32 | 27.3% | 32.6% |
| | | | | G-Ga535 | 1.45 | | | | | |
| Embo diment 7 | BG490 | 1.47 | 27.8 % | Y565 | 1.00 | 42.8 % | R630 | 1.55 | 29.4% | 34.6% |
| | | | | G-Ga535 | 1.26 | | | | | |

(continued)

| | The first additional luminous body | | | The second additional luminous body | | | The third additional luminous body | | | The total fluore scent powd er ratio |
|---|---|---|---|---|---|---|---|---|---|---|
| | Code | Weig ht (g) | Ratio | Code | Weig ht (g) | Ratio | Code | Wei ght (g) | Ratio | |
| Embo diment 8 | BG490 | 1.40 | 31.7 % | Y565 | 0.80 | 42.6 % | R630 | 1.13 | 25.6% | 30.6% |
| | | | | G-Ga535 | 1.08 | | | | | |

The weight of the fluorescent powder in the embodiments in Table 2 is the data used for manufacturing the sample chip of the light source module L1. In fact, in mass production, the weight will vary slightly due to different batches of fluorescent powder, but its basic ratio is in a fixed range. The application of the amount of the various fluorescent powders is mainly to control the energy ratio of the mixed emitted light in the specified wavelength. Because the energy distribution affects the CS value of the emitted light (the specific calculation method of CS value will be described in detail later in the case of introducing the spectrum of the embodiments), we have a basic requirement for the energy distribution in each range when designing the chip. Here, we only discuss the spectrum in the visible light range, so the entire spectral energy below refers to the total spectral energy in the visible light range, that is, in the wavelength range [380 ~ 780nm]. In the spectrum of emitted light of the chip: the spectral energy in the wavelength range [380 ~ 470nm] accounts for 12.0% ~ 32.0% of the entire spectral energy, and optionally 17.0% ~ 27.0%; the spectral energy in the wavelength range [470 ~ 560nm] accounts for 25.0% ~ 45.0% of the total spectral energy, and optionally 27.0% ~ 37.0%; the spectral energy in the wavelength range [560 ~ 780nm] accounts for 36.0% ~ 56.0% of the total spectral energy, and optionally 40.0% ~ 50.0%. In the previous RGB mixing schemes, the [470 ~ 520nm] range is usually a wavelength valley with little energy, but in the present application, we pay special attention to this range and increase the CS value by increasing the energy in this range. Therefore, the spectral energy in this range is required to account for 14.0% ~ 34.0% of the total spectral energy, and optionally 18.0% ~ 28.0%.

In the case that the energy division in each spectral range is basically determined, the fluorescent powder we use is also deployed based on this goal. The energy in the wavelength range [380 ~ 470nm] is provided by the blue LED chip of the first light-emitting element 1, and in fact, all the energy of the emitted light is provided by it. Originally, all the energy should be concentrated in this range, however, because part of the light is converted into other light colors by fluorescent powder, so the converted energy is distributed in other wavelength ranges, and the energy retained in this range is less than 32%. The spectral energy in the wavelength range [470 ~ 560nm] is mainly provided by the first additional luminous body 201 and the second additional luminous body 202 after converting part of the emitted light of the first light-emitting element 1. Here, it is "mainly", because the spectrum is continuous, and the emitted light of the first light-emitting element 1 itself is not completely energy-free in this range, but is relatively small compared to the energy after conversion. When designing the chip, we mainly consider the conversion part of the fluorescent powder, select a more appropriate powder weight ratio, and then actually measure the energy in this range. The measured energy can comprise the energy provided by each luminous body, but it is the first additional luminous body 201 and the second additional luminous body 202 that play a main role in this range. It can be seen from Table 2 that the ratio of the blue-green fluorescent powder as the first additional luminous body 201 in the total fluorescent powder weight is in the range of 26.1% to 33.3%. Considering that other types of fluorescent powder can be used, it is considered that the ratio of the first additional luminous body 201 in the total fluorescent powder weight should be in the range of 20% ~ 55%. The purpose of adding the second additional luminous body 202 in the present application is to increase the energy of the [470 ~ 520nm] range, but the energy of this range should not be too high, otherwise the color of white light will be affected. It can be seen from Table 2 that the fluorescent powder as the second additional luminous body 202 is basically a combination of the yellow fluorescent powder and green fluorescent powder, and its ratio in the total fluorescent powder weight is in the range of 39.9% to 46.6%, In the present application, it is considered that the ratio of the second additional luminous body 202 in the total fluorescent powder weight should be in the range of 22.0 ~ 52.0%. The spectral energy in the wavelength range [560 ~ 780nm] is mainly provided by the red fluorescent powder or the orange fluorescent powder as the third additional luminous body 203. In Table 2, the ratio of the third additional luminous body 203 in the total fluorescent powder weight is in the range of 25.6% to 29.4%. It is further considered that the ratio of other fluorescent powder other than the embodiments can be expanded to the range of 7% ~ 36%. These fluorescent powders may be coated on the LED chip by being mixed into the transparent silica gel, or they may be remote fluorescent powders that may be arranged far away from the chip, or partially mixed into the packaging glue and partially set on the external surface. The present application is not limited thereto.

The function of each additional luminous body in the light source module 1 is to receive part of the light emitted by the first light-emitting element 1 and convert it into light with other colors different from the first color. In the present embodiment, the emitted light of the light source module L1 is formed after the first color light, the second color light, the third color light and the fourth color light are mixed, and on the CIE1931 color space, the emitted light of the light source module L1 is the white light in the interval enclosed by the points with a correlated color temperature 5750 $\pm$ 400K and distances from the black body trajectory duv = -0.006 - 0.006.

Refer to the table above for detailed description of each implementation.

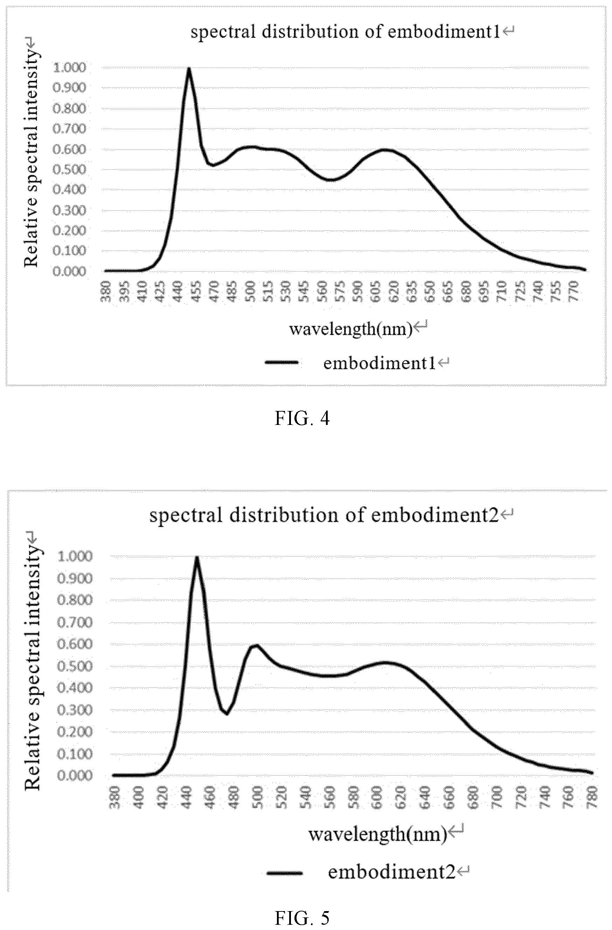

In the embodiment 1, in the light source module L1, the first light-emitting element 1 is a blue LED chip with Peak = 450 nm. Weigh and mix 0.70g of red fluorescent powder with the code of R640 and 0.61g of red fluorescent powder with the code R630 as the third additional luminous body 203. The second additional luminous body 202 is the yellow fluorescent powder with the code Y565, and the weight of the yellow powder is 1.95g. Weigh 1.63g of blue-green fluorescent powder with the code BG500 as the first additional luminous body 201. Put the above fluorescent powder into 10.00g transparent silica gel, mix it fully and evenly in a mixer, coat it on the blue LED chip, dry and remove bubbles to obtain a cold white LED chip, its spectrum is shown in FIG. 4, and the specific luminous characteristics are shown in Table 3.

In the embodiment 2, in the light source module L1, the first light-emitting element 1 is a blue LED chip with Peak = 450 nm. Weigh 1.46g of red fluorescent powder with the code R630 as the third additional luminous body 203. The second additional luminous body 202 is composed of 0.90g of green fluorescent powder with the code G-Si525 and 1.30g of green fluorescent powder with the code G-Ga535. Weigh 1.40g of blue-green fluorescent powder with the code BG490 as the first additional luminous body 201. Put the above fluorescent powder and 0.1g of light diffuser nano titanium oxide into 10.00g of transparent silica gel, mix it fully and evenly in a mixer, coat it on the blue LED chip, dry and remove bubbles to obtain a cold white LED chip, its spectrum is shown in FIG. 5, and the specific luminous characteristics are shown in Table 3.

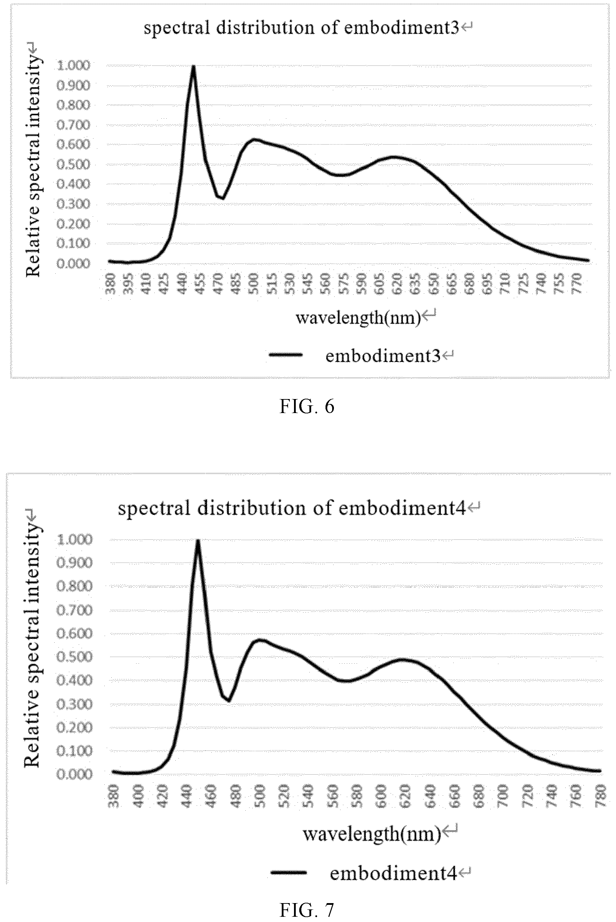

In the embodiment 3, in the light source module L1, the first light-emitting element 1 is a blue LED chip with Peak = 450 nm. Weigh 1.44g of red fluorescent powder with the code R630 as the third additional luminous body 203. The second additional luminous body 202 is composed of yellow fluorescent powder with the code Y565 and green fluorescent powder with the code G-Ga535, where the yellow fluorescent powder is 1.00g and the green fluorescent powder is 1.37g. Weigh 1.35g of blue-green fluorescent powder with the code BG490 as the first additional luminous body 201. Put the above fluorescent powder into 10.00g of transparent silica gel, mix it fully and evenly in a mixer, coat it on the blue LED chip, dry and remove bubbles to obtain a cold white LED chip, its spectrum is shown in FIG. 6, and the specific luminous characteristics are shown in Table 3.

In the embodiment 4, in the light source module L1, the first light-emitting element 1 is a blue LED chip with Peak = 450 nm. Weigh 1.22g of red fluorescent powder with the code R630 as the third additional luminous body 203. The second additional luminous body 202 is composed of 0.80g of green fluorescent powder with the code G-L535 and 1.15g of green fluorescent powder with the code G-Ga535. Weigh 1.32g of blue-green fluorescent powder with the code BG490 as the first additional luminous body 201. Put the above fluorescent powder into transparent silica gel, mix it fully and evenly in a mixer, coat it on the blue LED chip, dry and remove bubbles to obtain a cold white LED chip, its spectrum is shown in FIG. 7, and the specific luminous characteristics are shown in Table 3.

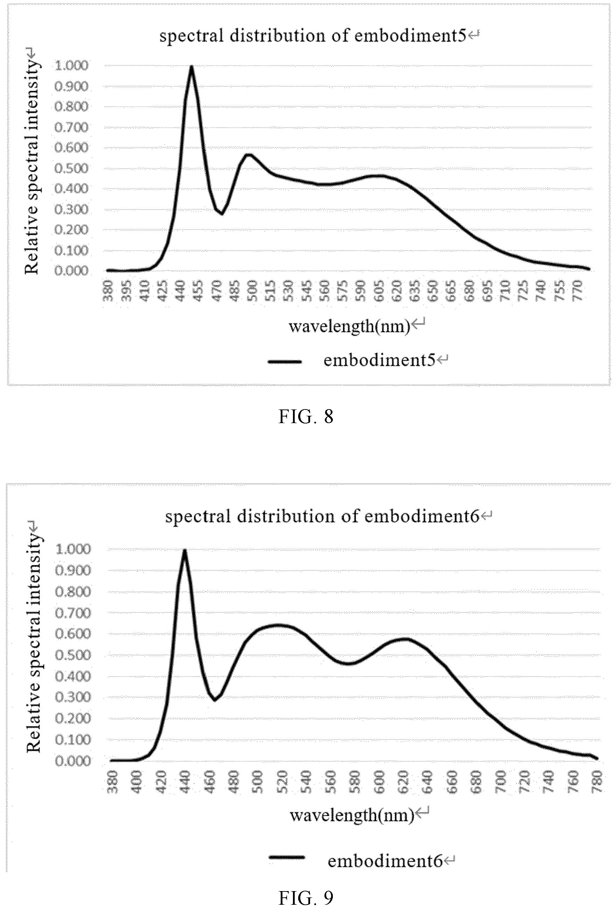

In the embodiment 5, in the light source module L1, the first light-emitting element 1 is a blue LED chip with Peak = 450 nm. Weigh 1.06g of red fluorescent powder with the code R630 as the third additional luminous body 203. The second additional luminous body 202 is composed of yellow fluorescent powder with the code Y550 and green fluorescent powder with the code G-L535, where the yellow fluorescent powder is 0.80g and the green fluorescent powder G-L535 is 0.95g. Weigh 1.23g of blue-green fluorescent powder with the code BG490 as the first additional luminous body 201. Put the above fluorescent powder into transparent silica gel, mix it fully and evenly in a mixer, coat it on the blue LED chip, dry and remove bubbles to obtain a cold white LED chip, its spectrum is shown in FIG. 8, and the specific luminous characteristics are shown in Table 3.

In the embodiment 6, in the light source module L1, the first light-emitting element 1 is a blue LED chip with Peak = 440 nm. Weigh 1.32g of red fluorescent powder with the code R630 as the third additional luminous body 203. The second additional luminous body 202 is composed of yellow fluorescent powder with the code Y565 and green fluorescent powder with the code G-Ga535, where the yellow fluorescent powder is 0.80g and the green fluorescent powder is 1.45g. Weigh 1.26g of blue-green fluorescent powder with the code BG500 as the first additional luminous body 201. Put the above fluorescent powder into transparent silica gel, mix it fully and evenly in a mixer, coat it on the blue LED chip, dry and remove bubbles to obtain a cold white LED chip, its spectrum is shown in FIG. 9, and the specific luminous characteristics are shown in Table 3.

In the embodiment 7, in the light source module L1, the first light-emitting element 1 is a blue LED chip with Peak = 455 nm. Weigh 1.55g of red fluorescent powder with the code R630 as the third additional luminous body 203.

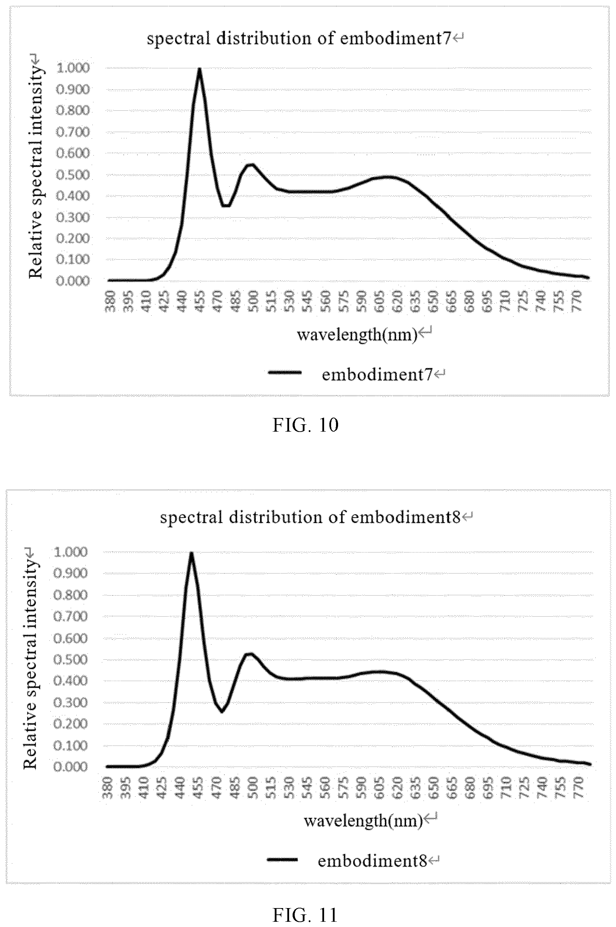

The second additional luminous body 202 is composed of yellow fluorescent powder with the code Y565 and green fluorescent powder with the code G-Ga535, where the yellow fluorescent powder is 1.00g and the green fluorescent powder is 1.26g. Weigh 1.47g of blue-green fluorescent powder with the code BG490 as the first additional luminous body 201. Put the above fluorescent powder into transparent silica gel, mix it fully and evenly in a mixer, coat it on the blue LED chip, dry and remove bubbles to obtain a positive white LED chip, its spectrum is shown in FIG. 10, and the specific luminous characteristics are shown in Table 3.

In the embodiment 8, in the light source module L1, the first light-emitting element 1 is a blue LED chip with Peak = 450 nm. Weigh 1.13g of red fluorescent powder with the code R630 as the third additional luminous body 203. The second additional luminous body 202 is composed of yellow fluorescent powder with the code Y565 and green fluorescent powder with the code G-Ga535, where the yellow fluorescent powder is 0.80g and the green fluorescent powder is 1.08g. Weigh 1.40g of blue-green phosphor with the code BG490 as the first additional luminous body 201. Put the above fluorescent powder into transparent silica gel, mix it fully and evenly in a mixer, coat it on the blue LED chip, dry and remove bubbles to obtain a day white LED chip, its spectrum is shown in FIG. 11, and the specific luminous characteristics are shown in Table 3.

Table 3

|  | x | y | CCT | duv | CRI | CS_500lux |
|---|---|---|---|---|---|---|
| Embodiment 1 | 0.3281 | 0.3373 | 5699 | 0.000 | 91.72 | 0.471 |
| Embodiment 2 | 0.3304 | 0.3371 | 5591 | -0.001 | 95.65 | 0.464 |
| Embodiment 3 | 0.3305 | 0.3501 | 5585 | 0.005 | 96.02 | 0.451 |
| Embodiment 4 | 0.3245 | 0.3384 | 5864 | 0.002 | 93.93 | 0.469 |
| Embodiment 5 | 0.3217 | 0.3295 | 6027 | -0.001 | 95.85 | 0.479 |
| Embodiment 6 | 0.3290 | 0.3436 | 5652 | 0.003 | 93.11 | 0.453 |
| Embodiment 7 | 0.3304 | 0.3317 | 5591 | -0.004 | 91.03 | 0.476 |
| Embodiment 8 | 0.3222 | 0.3233 | 6026 | -0.005 | 95.51 | 0.484 |

Table 3 lists the luminous characteristics of the light source modules L1 in embodiments 1-8, where x, y represent the coordinate values of the light color of the emitted light of the light source module L1 on the x and y axes on the CIE1931 color coordinate system, CCT is the color temperature, duv represents the distance and direction of the color offset Planck trajectory in the color coordinate system, and CRI is the color rendering index. The CS value 500lux in the present application represents the CS value of the emitted light of the light source module L1 at the illuminance of 500lux. The specific calculation formula is as follows:

$$CS = 0.7 - \frac{0.7}{1 + \left(\frac{CL_A}{355.7}\right)^{1.1026}}$$

where,

$$CL_A = 1548 \times \left\{ \int Mc(\lambda)P(\lambda)d\lambda + 0.7 \times \left( \int \frac{s(\lambda)}{mp(\lambda)} P(\lambda)d\lambda - 0.2616 \times \int \frac{v(\lambda)}{mp(\lambda)} P(\lambda)d\lambda \right) - 3.3 \times \left( 1 - e^{\left(\frac{\int V'(\lambda)*P(\lambda)*d\lambda'}{-6.5}\right)} \right) \right\}$$

,if $\left( \int \frac{s(\lambda)}{mp(\lambda)} P(\lambda)d\lambda - 0.2616 \times \int \frac{v(\lambda)}{mp(\lambda)} P(\lambda)d\lambda \right) > 0$ ;

$CL_A = 1548 \times \left\{ \int Mc(\lambda)P(\lambda)d\lambda \right\}$, if $\left( \int \frac{s(\lambda)}{mp(\lambda)} P(\lambda)d\lambda - 0.2616 \times \int \frac{V(\lambda)}{mp(\lambda)} P(\lambda)d\lambda \right) \leq 0$

, where $P(\lambda) = \frac{500 \times P_0(\lambda)}{683 \times \sum V(\lambda)P_0(\lambda)d\lambda}$ , $P_0(\lambda)$: the spectral distribution of light source; $P(\lambda)$: the spectral distribution corresponding to the light source of 500 lux; $Mc(\lambda)$: melanopsin sensitivity curve corrected by lens transmittance; $S(\lambda)$: S-type cone cell sensitivity curve; $mp(\lambda)$: macular pigment transmittance; $V(\lambda)$: luminous efficiency function; $V'(\lambda)$: dark visual efficiency function; the calculation formula is based on the mathematical model of human rhythm light conduction published by LRC.

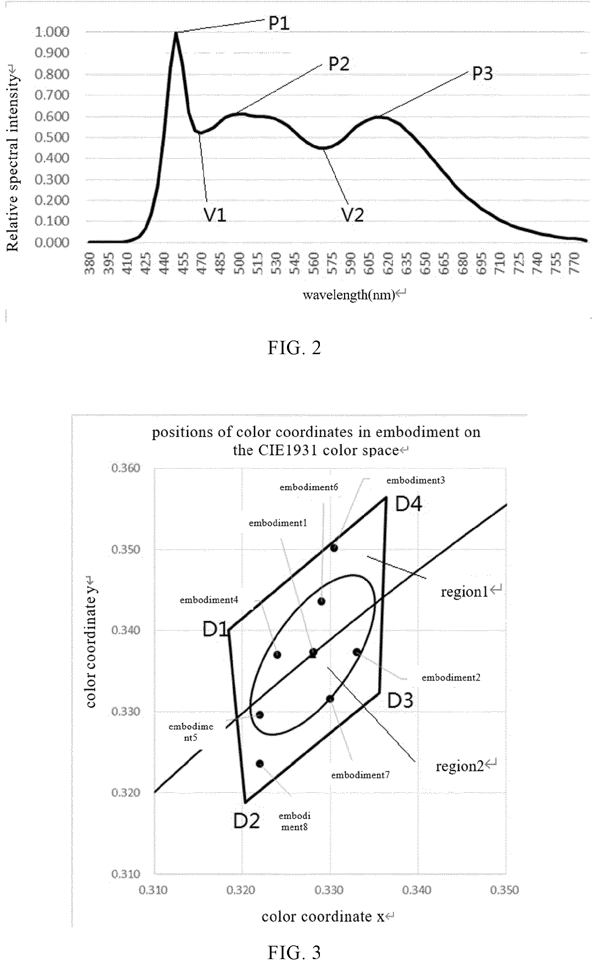

From table 3, we can see that the CS values of the emitted light of the light source modules L1 of all the embodiments at the illuminance of 500lux are greater than 0.45, and the color rendering indexes conform to CRI ≥ 90.0. We mark the luminous light color in each embodiment on the CIE1931 color coordinate system. As shown in FIG. 3, the light color of each embodiment falls near the black body trajectory with a correlated color temperature of 5750 ± 400K, and the distance from the black body trajectory BBL is less than 0.006, that is, duv is in this range of -0.006 ~ 0.006, and all points fall in the quadrilateral region enclosed by four vertices D1 (0.3184,0.3401), D2 (0.3203,0.3189), D3 (0.3356,0.3323) and D4 (0.3364,0.3564), that is, the region 1 in the figure. After conducting user experiments on these embodiments in the later stage, it is found that the effects of the embodiments 1, 2, 4, 5, 6 and 7 are better, and from FIG. 3, it can be found that these points all fall into the region 2 shown in figure, and the region 2 is an ellipse with the central point x0 = 0.3281, y0 = 0.3372, the long axis a = 0.00223, the short axis b = 0.00095, the inclination angle θ= 58.2 °, and SDCM = 5.0.

The reason why the embodiments provided by us can achieve high CS value is mainly due to the energy distribution of the emitted light at different wavelengths. These characteristics are more specifically reflected in the waveform features of the spectrum in addition to the different energy distribution in the different wavelength regions defined earlier. FIG. 2 is a schematic spectrum diagram that best reflects the spectral characteristics of the emitted light of the light source module L1 of the present application. We will describe the spectral characteristics of the present application according to FIG. 2. As can be seen from FIG. 2, the spectrum of the emitted light comprises a first peak P1, a first peak valley V1, a second peak P2, a second peak valley V2 and a third peak P3 distributed in sequence.

The first peak P1 is located in the wavelength region of 435 ~ 465nm. Since the light source module L1 uses the blue LED chip of the first light-emitting element 1 as the excitation light source, although a large part of the light emitted by the blue LED chip has been wavelength-converted by additional luminous bodies, there is still a part of the energy that has not been converted. These energies form the first peak in the wavelength region of 435 ~ 465nm. The P1 point may be the same as the peak wavelength of the blue LED chip, because the main source of the energy of this peak is the first light-emitting element 1, but the light converted by each additional luminous body may also have part of energy in this wavelength band. After the two are mixed, this first peak P1 does not necessarily coincide with the position of the peak wavelength of the blue LED chip of the original first light-emitting element 1, and may drift slightly, but it is still in the wavelength region of 435 ~ 465 nm. The first peak P1 is basically located in the range of [380 ~ 470nm], so the energy of the wavelength in the [380 - 470nm] range is mainly the energy of the first peak P1.

The second peak P2 is located in the wavelength region of 485 ~ 525nm. The energy of the second peak P2 is provided by blue-green light, the blue-green fluorescent powder of the first light-emitting element 1 receives part of the light emitted by the blue LED chip of the first light-emitting element 1 and converts it into the blue-green light. The ratio of the spectral intensity of the second peak P2 to the spectral intensity of the first peak P1 is in the range of 45% ~ 85%, and optionally 55 - 75%.

The third peak P3 is located in the wavelength region of 595 ~ 645nm. The energy of the third peak P3 is provided by red light, the red fluorescent powder or orange fluorescent powder of the third additional luminous body 203 receives part of the light emitted by the blue LED chip of the first light-emitting element 1 converts it into the red light. The ratio of the spectral intensity of the third peak P3 to the spectral intensity of the first peak P1 is in the range of 40% ~ 70%, and optionally 42 ~ 60%. The spectral energy of emitted light in the wavelength range of [560 ~ 780nm] is mainly provided by the third peak P3.

The first peak valley V1 is the lowest point in the spectrum between the first peak P1 and the second peak P2, and the energies at the bottom of the two peaks are superimposed here. Therefore, the ratio of the spectral intensity of the first peak valley V1 to the spectral intensity of the first peak P1 may be greater than or equal to 25.0%.

The second peak valley V2 is the lowest point in the spectrum between the second peak P2 and the third peak P3. Since the second peak P2 and the third peak P3 are far apart, only relying on the energy of the second peak P2, it cannot be ensured that the spectral energy of the emitted light in the wavelength range [470 ~ 560 nm] remains 25.0% ~ 45.0% of the entire spectral energy. Therefore, the second additional luminous body 202 is added in the present application, the second additional luminous body 202 receives part of the light emitted by the blue LED chip of the first light-emitting element 1 and converting it into the yellow and green light, and the energy provided by the yellow and green light is distributed in the region of [470 ~ 520nm]. This energy distribution also raises the second peak valley V2, so that the ratio of the spectral intensity of the second peak valley V2 to the spectral intensity of the first peak P1 is in the range of 30.0% ~ 60.0%, and optionally 35.0% ~ 50.0%. Here we explain again that, generally, selecting yellow or green fluorescent powder for the second additional luminous body can also ensure the energy ratio of this position, however, the spectrum fluctuates greatly, and another peak may be formed between the second peak P2 and the third peak P3. Of course, the appearance of the new peak does not affect the CS value of the entire spectrum, and the second peak valley V2 is still the lowest point in the spectrum located between the second peak P2 and the third peak P3. However, from the perspective of color rendering, the energy distribution in this range is more uniform. Therefore, in the optional embodiments 3, 5, 6, 7 and 8, the second additional luminous body 202 adopts a mixture of two kinds of fluorescent powders with different peak wavelengths, and optionally, the two kinds of fluorescent powder select fluorescent powders of different colors, that is, one is yellow fluorescent powder and the other is green fluorescent powder. After the two kinds of fluorescent powders are mixed, part of the emitted light of the first light-emitting element 1 is converted to provide the main energy in the wavelength range of [470 ~ 520nm]. The energy in the wavelength range of [470 ~ 570nm] is provided by the first additional luminous body 201 together with the second additional luminous body 202.

The positions of the above peaks can basically ensure the energy ratio in each range, but further limiting the peak energy ratio between the second peak P2 and the third peak P3 can obtain better luminous effects, further ensure the acquisition of high CS values, and ensure high luminous efficiency and high color rendering. In a preferred embodiment, the ratio of the spectral intensity of the third peak P3 to the spectral intensity of the second peak P2 is in the range of 75% ~ 105%, and optionally 80% ~ 100%.

In FIG. 2, we can see that the spectrum of the emitted light is continuously distributed. The so-called continuous distribution means that the spectral curve is relatively smooth and there is no large energy fluctuation between adjacent two points. As shown in the spectrum diagrams of FIG. 4-FIG. 11 of each of the embodiments, there is no point with spectral energy of 0 between several peaks, such a spectral curve can ensure that there is a certain energy distribution at every point in the range of 380 ~ 780nm, so that the spectrum has better color rendering.

Table 4 lists the characteristic values of each spectrum of embodiments 1-8. P1, P2, P3, V1 and V2 in the table refer to the wavelength of the first peak P1, the second peak P2, the third peak P3, the first peak valley V1 and the second peak valley V2, respectively, the unit is nm. I_P2/I_P1 refers to the ratio of the spectral intensity of the second peak P2 to the spectral intensity of the first peak P1, I_P3/I_P1 refers to the ratio of the spectral intensity of the third peak P3 to the spectral intensity of the first peak P1, I_V1/I_ P1 refers to the ratio of the spectral intensity of the first peak valley V1 to the spectral intensity of the first peak P1, I_V2/I_P1 refers to the ratio of the spectral intensity of the second peak valley V2 to the spectral intensity of the first peak P1, I_P3/I_P2 refers to the ratio of the spectral intensity of the third peak P3 to the spectral intensity of the second peak P2.

Table 4

|  | P1 (nm) | P2 (nm) | P3 (nm) | V1 (nm) | V2 (nm) | I_P2/ I_P1 | I_P3/ I_P1 | I_V1/ I_P1 | I_V2/ I_P1 | I_P3/ I_P2 |
|---|---|---|---|---|---|---|---|---|---|---|
| Embodiment 1 | 450.0 | 500.0 | 615.0 | 465.0 | 570.0 | 61.2% | 59.8% | 52.2% | 44.9% | 97.7% |
| Embodiment 2 | 450.0 | 500.0 | 615.0 | 475.0 | 560.0 | 59.3% | 51.6% | 28.2% | 45.4% | 86.9% |
| Embodiment 3 | 450.0 | 500.0 | 620.0 | 475.0 | 575.0 | 62.5% | 53.8% | 32.9% | 44.7% | 86.1% |
| Embodiment 4 | 450.0 | 500.0 | 620.0 | 475.0 | 570.0 | 57.4% | 48.8% | 31.5% | 39.9% | 85.1% |
| Embodiment 5 | 450.0 | 500.0 | 600.0 | 475.0 | 560.0 | 56.6% | 46.3% | 27.8% | 42.3% | 81.7% |
| Embodiment 6 | 440.0 | 515.0 | 625.0 | 465.0 | 575.0 | 64.0% | 57.7% | 28.8% | 45.8% | 90.2% |
| Embodiment 7 | 455.0 | 500.0 | 610.0 | 480.0 | 540.0 | 54.6% | 49.0% | 35.4% | 41.9% | 89.8% |
| Embodiment 8 | 450.0 | 500.0 | 605.0 | 475.0 | 630.0 | 52.7% | 44.5% | 25.9% | 41.0% | 84.4% |

These characteristic values all fall in the range of the spectral features described above. Because of these characteristics, the embodiments 1-8 with these spectral features can achieve the energy ratio in the defined ranges. Table 5 lists the energy ratio in the specified range in each spectrum of embodiments 1-8. I_$\Sigma$ [380-470] nm, I_$\Sigma$ (470-520] nm, I_$\Sigma$ [470-560] nm, I_$\Sigma$ (560-780] nm, respectively represent the ratio of spectral energy of the listed wavelength range in the entire spectral energy.

Table 5

|  | I_$\Sigma$ [380-470] nm | I_$\Sigma$ (470-520] nm | I_$\Sigma$ [470-560] nm | I_$\Sigma$ (560-780] nm |
|---|---|---|---|---|
| Embodiment 1 | 18.9% | 20.7% | 35.8% | 45.3% |
| Embodiment 2 | 19.7% | 19.3% | 34.1% | 46.2% |
| Embodiment 3 | 17.7% | 19.8% | 35.3% | 47.0% |
| Embodiment 4 | 19.2% | 19.8% | 34.8% | 46.0% |
| Embodiment 5 | 21.1% | 19.8% | 34.6% | 44.3% |
| Embodiment 6 | 19.2% | 19.2% | 34.9% | 45.9% |

(continued)

|  | I_$\Sigma$ [380-470] nm | I_$\Sigma$ (470-520] nm | I_$\Sigma$ [470-560] nm | I_$\Sigma$ (560-780] nm |
|---|---|---|---|---|
| Embodiment 7 | 19.7% | 19.2% | 33.2% | 47.1% |
| Embodiment 8 | 21.8% | 18.8% | 33.2% | 44.9% |

The energy ratio of each range in Table 5 can ensure that the embodiments 1-8 achieve the luminous characteristics of high CS values.

The above detailed description of embodiments of the present invention is for illustration and description and is not intended to exhaust or limit the present invention to the specific forms disclosed. Obviously, many modifications and changes may be made, which may be obvious to those skilled in the art and should be comprised in the scope of the present invention defined by the appended claims.

**Claims**

1. A light source module (L1), comprising a first light-emitting element (1) and a packaging part (2) covering the first light-emitting element (1),

the first light-emitting element (1) emits first color light with a peak wavelength of 435 ~ 465 nm;
the packaging part (2) comprises:

a first additional luminous body (201) which is arranged to receive part of light emitted by the first light-emitting element (1) and convert it into second color light with a peak wavelength of 485 - 515 nm;
a second additional luminous body (202) which is arranged to receive part of light emitted by the first light-emitting element (1) and convert it into third color light with a peak wavelength of 520 ~ 580nm;
a third additional luminous body (203) which is arranged to receive part of light emitted by the first light-emitting element (1) and convert it into fourth color light with a peak wavelength of 615 - 655 nm,
the first color light, the second color light, the third color light and the fourth color light are mixed to form emitted light of the light source module (L1), wherein the emitted light is cold white light, that is, on a CIE1931 color space, the emitted light is located in an interval enclosed by points with correlated color temperature of 5750 $\pm$ 400K and distances from black body trajectory duv = -0.006 - 0.006,
a spectrum of the emitted light has following features achieved by selecting the appropriate powder weight ratio:

defining a spectral energy of the spectrum of the emitted light in a visible light range, that is, a wavelength range [380 - 780nm], as an entire spectral energy of the emitted light;
a spectral energy in a wavelength range [380 - 470nm] accounts for 12.0% - 32.0% of the entire spectral energy;
a spectral energy in a wavelength range [470 ~ 560nm] accounts for 25.0% - 45.0% of the entire spectral energy;
a spectral energy in a wavelength range [560 ~ 780nm] accounts for 36.0% - 56.0% of the entire spectral energy; and
a spectral energy in a wavelength range [470 ~ 520nm] accounts for 14.0% ~ 34.0% of the entire spectral energy;
wherein the first light-emitting element (1) is a blue LED emitting light with the peak wavelength of 435 ~ 465nm; the first additional luminous body (201) is blue-green fluorescent powder with the peak wavelength of 485 ~ 515nm and a half width of 25 ~ 65nm; the second additional luminous body (202) is yellow fluorescent powder and/or green fluorescent powder with the peak wavelength of 520 ~ 580nm and a half width of 60 ~ 115nm; the third additional luminous body (203) is red fluorescent powder or orange fluorescent powder with the peak wavelength of 615 ~ 655nm and a half width of 80 ~ 120nm, and defining a total weight of the first additional luminous body (201), the second additional luminous body (202) and the third additional luminous body (203) to be a total fluorescent powder weight;
wherein a ratio of the first additional luminous body (201) in the total fluorescent powder weight ranges from 20.0% to 55.0%;
wherein a ratio of the second additional luminous body (202) in the total fluorescent powder weight ranges from 22.0% to 52.0%; and
wherein a ratio of the third additional luminous body (203) in the total fluorescent powder weight ranges from 7.0% to 36.0%.

2. The light source module (L1) according to claim 1, wherein in the spectrum of the emitted light:

the spectral energy in the wavelength range [380 ~ 470nm] accounts for 17.0% ~ 27.0% of the entire spectral energy;
the spectral energy in the wavelength range [470 ~ 560nm] accounts for 27.0% ~ 37.0% of the entire spectral energy;
the spectral energy in the wavelength range [560 ~ 780nm] accounts for 40.0% ~ 50.0% of the entire spectral energy; and
the spectral energy in the wavelength range [470 ~ 520nm] accounts for 18.0% ~ 28.0% of the entire spectral energy.

3. The light source module (L1) according to claim 1, wherein the spectrum of the emitted light is continuously distributed in the visible light range of 380 ~ 780nm, and comprises three peaks and two peak valleys, wherein

a first peak (P1) is located in a wavelength range of 435 ~ 465 nm;
a second peak (P2) is located in a wavelength range of 485 ~ 525nm, and a ratio of a spectral intensity of the second peak to a spectral intensity of the first peak ranges from 45.0% to 85.0%;
a first peak valley (V1) is located between the first peak (P1) and the second peak (P2), and a ratio of a spectral intensity of the first peak valley (V1) to the spectral intensity of the first peak (P1) is greater than or equal to 25.0%;
a third peak (P3) is located in a wavelength range of 595 ~ 645nm, and a ratio of a spectral intensity of the third peak (P3) to the spectral intensity of the first peak (P1) ranges from 40.0% to 70.0%; and
a second peak valley (V2) is located between the second peak (P2) and the third peak (P3), and a ratio of a spectral intensity of the second peak valley (V2) to the spectral intensity of the first peak (P1) ranges from 30.0% to 60.0%.

4. The light source module (L1) according to claim 3, wherein in the spectrum of the emitted light:

the ratio of the spectral intensity of the second peak (P2) to the spectral intensity of the first peak (P1) ranges from 55.0% to 75.0%;
the ratio of the spectral intensity of the third peak (P3) to the spectral intensity of the first peak (P1) ranges from 42.0% to 60.0%; and
the ratio of the spectral intensity of the second peak valley (V2) to the spectral intensity of the first peak (P1) ranges from 35.0% to 50.0%.

5. The light source module (L1) according to claim 3, wherein in the spectrum of the emitted light: the ratio of the spectral intensity of the third peak (P3) to the spectral intensity of the second peak (P2) ranges from 75% to 105%.

6. The light source module (L1) according to claim 5, wherein in the spectrum of the emitted light: the ratio of the spectral intensity of the third peak (P3) to the spectral intensity of the second peak (P2) ranges from 80% to 100%.

7. The light source module (L1) according to claim 1, wherein the blue-green fluorescent powder is formed by mixing any one or more of following fluorescent powders:

(a) nitrogen oxide with $Eu^{2+}$ as an activator, and

general chemical composition formula: $(Ba,Ca)_{1-x}Si_2N_2O_2:Eu_x$, where x = 0.005 ~ 0.200;

(b) Ga doped garnet fluorescent powder with $Eu^{2+}$ as an activator, and
general chemical composition formula: Ga-LuAG:Eu;
(c) silicate fluorescent powder with $Eu^{2+}$ as an activator, and
general chemical composition formula: $Ba_2SiO_4:Eu$.

8. The light source module (L1) according to claim 1, wherein the yellow fluorescent powder/green fluorescent powder is formed by mixing any one or more of following fluorescent powders:

(a) garnet structure fluorescent powder with $Ce^{3+}$ as an activator, and

general chemical composition formula: $(M1)_{3-x}(M2)_5O_{12}:Ce_x$,
where M1 is at least one element selected from a group consisting of Y, Lu, Gd and La, M2 is at least one element selected from a group consisting of Al and Ga, and x = 0.005 ~ 0.200;

(b) silicate system fluorescent powder with $Eu^{2+}$ as an activator, and

general chemical composition formula: $(M3)_{2-x}SiO_4:Eu_x$
or $(Ba,Ca,Sr)_{2-x}(Mg,Zn)Si_2O_7:Eu_x$,
where M3 is at least one element selected from a group consisting of Mg, Sr, Ca and Ba, and x = 0.01 ~ 0.20;

(c) nitrogen oxide fluorescent powder (Cylon $\beta$ - SiALON) with $Eu^{2+}$ as an activator, and general chemical composition formula: $Si_bAl_cO_dN_e:Eu_x$,
where x = 0.005 ~ 0.400, b + c = 12, and d + e = 16;
(d) aluminate system fluorescent powder with $Eu^{2+}$ as an activator, and

general chemical composition formula: $(Sr,Ba)_{2-x}Al_2O_4:Eu_x$
or $(Sr,Ba)_{4-x}Al_{14}O_{25}:Eu_x$,
where x = 0.01 ~ 0.15.

9. The light source module (L1) according to claim 1, wherein the red fluorescent powder or the orange fluorescent powder is formed by mixing any one or more of following fluorescent powders:

(a) nitride red powder having a 1113 crystal structure with $Eu^{2+}$ as an activator, and general chemical composition formula: $(M4)_{1-x}AlSiN_3:Eu_x$,
where M4 is at least one element selected from a group consisting of Ca, Sr and Ba, x = 0.005 ~ 0.300;
(b) nitride red powder having a 258 crystal structure with $Eu^{2+}$ as an activator, and general chemical composition formula: $(M5)_{2-x}Si_5N_8:Eu_x$,
where M5 is at least one element selected from a group consisting of Ca, Sr, Ba and Mg, x = 0.005 - 0.300;
(c) nitrogen oxide fluorescent powder (Cylon $\alpha$ - SiALON) with $Eu^{2+}$ as an activator, and general chemical composition formula: $((M6)_{1-a})_xSi_bAl_cO_dN_e:Eu_a$,
where M6 is at least one element selected from a group consisting of Li, Na, K, Rb, Cs, Sr, Ba, Sc, Y, La and Gd, x = 0.15 ~ 1.5, a = 0.005 ~ 0.300, b + c = 12, and d + e = 16;
(d) silicate fluorescent powder with $Eu^{2+}$ as an activator, and
general chemical composition formula: $(Sr,Ba)_{3-x}Si_5O_5:Eu_x$.

10. The light source module (L1) according to claim 1, wherein the packaging part (2) further comprises a base material (204) and a light diffuser, the base material (204) is silica gel or resin, and the light diffuser is one selected from a group consisting of nano titanium oxide, nano alumina and nano silicon oxide.

11. The light source module (L1) according to any one of claims 1-10, wherein on the CIE1931 color space, light color of the emitted light of the light source module (L1) is located in a quadrilateral region enclosed by four vertices D1 (0.3184,0.3401), D2 (0.3203,0.3189), D3 (0.3356,0.3323) and D4 (0.3364,0.3564).

12. The light source module (L1) according to claim 11, wherein on the CIE1931 color space, the light color of the emitted light of the light source (L1) module is located within an elliptical range with a center point x0 = 0.3281, y0 = 0.3372, a long axis a = 0.00223, a short axis b = 0.00095, an inclination angle $\theta$ = 58.2 °, and a standard deviation color matching SDCM = 5.0.

13. The light source module (L1) according to any one of claims 1-11, wherein in a case that the emitted light of the light source module (L1) has an illuminance of 500lux, a circadian stimulus CS value is $\geq$ 0.45.

14. The light source module (L1) according to any one of claims 1-11, wherein a color rendering index CRI of the emitted light of the light source module (L1) is $\geq$ 90.0.

**15.** A lighting device (D1) comprising the light source module (L1) according to any one of claims 1 to 14.

**Patentansprüche**

**1.** Lichtquellenmodul (L1), das ein erstes lichtemittierendes Element (1) und ein Packungsteil (2) aufweist, welches das erste lichtemittierende Element (1) bedeckt,

wobei das erste lichtemittierende Element (1) Licht in einer ersten Farbe mit einer Peak-Wellenlänge von 435 ~ 465 nm emittiert;
wobei das Packungsteil (2) aufweist:

einen ersten zusätzlichen Leuchtkörper (201), der so angeordnet ist, dass er einen Teil des von dem ersten lichtemittierenden Element (1) emittierten Lichts aufnimmt und dieses in Licht in einer zweiten Farbe mit einer Peak-Wellenlänge von 485 ~ 515 nm umwandelt;
einen zweiten zusätzlichen Leuchtkörper (202), der so angeordnet ist, dass er einen Teil des von dem ersten lichtemittierenden Element (1) emittierten Lichts aufnimmt und dieses in Licht in einer dritten Farbe mit einer Peak-Wellenlänge von 520 ~ 580 nm umwandelt;
einen dritten zusätzlichen Leuchtkörper (203), der so angeordnet ist, dass er einen Teil des von dem ersten lichtemittierenden Element (1) emittierten Lichts aufnimmt und dieses in Licht in einer vierten Farbe mit einer Peak-Wellenlänge von 615 ~ 655 nm umwandelt,
wobei das Licht in erster Farbe, das Licht in zweiter Farbe, das Licht in dritter Farbe und das Licht in vierter Farbe gemischt werden, um emittiertes Licht des Lichtquellenmoduls (L1) zu bilden, wobei das emittierte Licht kaltweißes Licht ist, d. h. auf einem CIE1931 Farbraum, wobei sich das emittierte Licht in einem Intervall befindet, das von Punkten mit einer korrelierten Farbtemperatur von 5750 $\pm$ 400 K und Abständen von der Trajektorie des schwarzen Körpers duv = -0,006 ~ 0,006 umgeben wird,
wobei ein Spektrum des emittierten Lichts die folgenden Merkmale aufweist, die durch Auswahl des angemessenen Pulvergewichtverhältnisses erreicht werden:

Definieren einer Spektralenergie des Spektrums des emittierten Lichts in einem sichtbaren Lichtbereich, d. h. einem Wellenlängenbereich [380 ~ 780 nm], als eine gesamte Spektralenergie des emittierten Lichts;
wobei eine Spektralenergie in einem Wellenlängenbereich [380 ~ 470 nm] 12,0 % ~ 32,0 % der gesamten Spektralenergie ausmacht;
wobei eine Spektralenergie in einem Wellenlängenbereich [470 ~ 560 nm] 25,0 % ~ 45,0 % der gesamten Spektralenergie ausmacht;
wobei eine Spektralenergie in einem Wellenlängenbereich [560 ~ 780 nm] 36,0 % ~ 56,0 % der gesamten Spektralenergie ausmacht; und
wobei eine Spektralenergie in einem Wellenlängenbereich [470 ~ 520 nm] 14,0 % ~ 34,0 % der gesamten Spektralenergie ausmacht;
wobei das erste lichtemittierende Element (1) eine blaue LED ist, die Licht mit der Peak-Wellenlänge von 435 ~ 465 nm emittiert;
wobei der erste zusätzliche Leuchtkörper (201) ein blaugrünes Leuchtpulver mit der Peak-Wellenlänge von 485 ~ 515 nm und einer halben Breite von 25 ~ 65 nm ist;
wobei der zweite zusätzliche Leuchtkörper (202) gelbes Leuchtpulver und/oder grünes Leuchtpulver mit der Peak-Wellenlänge von 520 ~ 580 nm und einer halben Breite von 60 ~ 115 nm ist;
wobei der dritte zusätzliche Leuchtkörper (203) rotes Leuchtpulver oder oranges Leuchtpulver mit der Peak-Wellenlänge von 615 ~ 655 nm und einer halben Breite von 80 ~ 120 nm ist, und
Definieren eines Gesamtgewichts des ersten zusätzlichen Leuchtkörpers (201), des zweiten zusätzlichen Leuchtkörpers (202) und des dritten zusätzlichen Leuchtkörpers (203) als ein Leuchtpulver-Gesamtgewicht;
wobei ein Anteil des ersten zusätzlichen Leuchtkörpers (201) am Leuchtpulver-Gesamtgewicht zwischen 20,0 % und 55,0 % liegt;
wobei ein Anteil des zweiten zusätzlichen Leuchtkörpers (202) am Leuchtpulver-Gesamtgewicht zwischen 22,0 % und 52,0 % liegt; und
wobei ein Anteil des dritten zusätzlichen Leuchtkörpers (203) am Leuchtpulver-Gesamtgewicht zwischen 7,0 % und 36,0 % liegt.

2. Lichtquellenmodul (L1) nach Anspruch 1, wobei in dem Spektrum des emittierten Lichts:

die Spektralenergie in dem Wellenlängenbereich [380 ~ 470 nm] 17,0 % ~ 27,0 % der gesamten Spektralenergie ausmacht;
die Spektralenergie in dem Wellenlängenbereich [470 ~ 560 nm] 27,0 % ~ 37,0 % der gesamten Spektralenergie ausmacht;
die Spektralenergie in dem Wellenlängenbereich [560 ~ 780 nm] 40,0 % ~ 50,0 % der gesamten Spektralenergie ausmacht; und
die Spektralenergie in dem Wellenlängenbereich [470 ~ 520 nm] 18,0 % ~ 28,0 % der gesamten Spektralenergie ausmacht.

3. Lichtquellenmodul (L1) nach Anspruch 1, wobei das Spektrum des emittierten Lichts kontinuierlich in dem sichtbaren Lichtbereich von 380 ~ 780 nm verteilt ist und drei Peaks und zwei Peak-Täler aufweist, wobei ein erster Peak (P1) sich in einem Wellenlängenbereich von 435 ~ 465 nm befindet;

ein zweiter Peak (P2) sich in einem Wellenlängenbereich von 485 ~ 525 nm befindet, und ein Verhältnis einer spektralen Intensität des zweiten Peaks zu einer spektralen Intensität des ersten Peaks zwischen 45,0 % und 85,0 % liegt;
ein erstes Peak-Tal (V1) sich zwischen dem ersten Peak (P1) und dem zweiten Peak (P2) befindet, und ein Verhältnis einer spektralen Intensität des ersten Peak-Tals (V1) zur spektralen Intensität des ersten Peaks (P1) größer als oder gleich 25,0 % ist;
ein dritter Peak (P3) sich in einem Wellenlängenbereich von 595 ~ 645 nm befindet, und ein Verhältnis einer spektralen Intensität des dritten Peaks (P3) zur spektralen Intensität des ersten Peaks (P1) zwischen 40,0 % und 70,0 % liegt; und
ein zweites Peak-Tal (V2) sich zwischen dem zweiten Peak (P2) und dem dritten Peak (P3) befindet, und ein Verhältnis einer spektralen Intensität des zweiten Peak-Tals (V2) zur spektralen Intensität des ersten Peaks (P1) zwischen 30,0 % und 60,0 % liegt.

4. Lichtquellenmodul (L1) nach Anspruch 3, wobei in dem Spektrum des emittierten Lichts:

das Verhältnis der spektralen Intensität des zweiten Peaks (P2) zur spektralen Intensität des ersten Peaks (P1) zwischen 55,0 % und 75,0 % liegt;
das Verhältnis der spektralen Intensität des dritten Peaks (P3) zur spektralen Intensität des ersten Peaks (P1) zwischen 42,0 % und 60,0 % liegt; und
das Verhältnis der spektralen Intensität des zweiten Peak-Tals (V2) zur spektralen Intensität des ersten Peaks (P1) zwischen 35,0 % und 50,0 % liegt.

5. Lichtquellenmodul (L1) nach Anspruch 3, wobei in dem Spektrum des emittierten Lichts:
das Verhältnis der spektralen Intensität des dritten Peaks (P3) zur spektralen Intensität des zweiten Peaks (P2) zwischen 75 % und 105 % liegt.

6. Lichtquellenmodul (L1) nach Anspruch 5, wobei in dem Spektrum des emittierten Lichts:
das Verhältnis der spektralen Intensität des dritten Peaks (P3) zur spektralen Intensität des zweiten Peaks (P2) zwischen 80 % und 100 % liegt.

7. Lichtquellenmodul (L1) nach Anspruch 1, wobei das blaugrüne Leuchtpulver durch Mischen von einem oder mehreren der folgenden Leuchtpulver gebildet wird:

(a) Stickoxid mit $Eu^{2+}$ als Aktivator, und

allgemeine chemische Zusammensetzungsformel: $(Ba,Ca)_{1-x}Si_2N_2O_2: Eu_x$,
wobei x = 0,005 ~ 0,200;

(b) Ga-dotiertes Granat-Leuchtpulver mit $Eu^{2+}$ als Aktivator, und allgemeine chemische Zusammensetzungsformel: Ga-LuAG:Eu;
(c) Silikat-Leuchtpulver mit $Eu^{2+}$ als Aktivator, und
allgemeine chemische Zusammensetzungsformel: $Ba_2SiO_4: Eu$.

8. Lichtquellenmodul (L1) nach Anspruch 1, wobei das gelbe Leuchtpulver/grüne Leuchtpulver durch Mischen von einem oder mehreren der folgenden Leuchtpulver gebildet wird:

(a) Granatstruktur-Leuchtpulver mit $Ce^{3+}$ als Aktivator, und

allgemeine chemische Zusammensetzungsformel: $(M1)_{3-x}(M2)_5O_{12}:Ce_x$,
wobei M1 mindestens ein Element ausgewählt aus einer Gruppe bestehend aus Y, Lu, Gd und La ist, M2 mindestens ein Element ausgewählt aus einer Gruppe bestehend aus Al und Ga ist, und x = 0,005 ~ 0,200;

(b) Silikat-System-Leuchtpulver mit $Eu^{2+}$ als Aktivator, und

allgemeine chemische Zusammensetzungsformel: $(M3)_{2-x}SiO_4:Eu_x$ oder $(Ba,Ca,Sr)_{2-x}(Mg,Zn)Si_2O_7:Eu_x$,
wobei M3 mindestens ein Element ausgewählt aus einer Gruppe bestehend aus Mg, Sr, Ca und Ba ist, und x = 0,01 ~ 0,20;

(c) Stickoxid-Leuchtpulver (Zyklon β SiALON) mit $Eu^{2+}$ als Aktivator, und

allgemeine chemische Zusammensetzungsformel: $Si_bAl_cO_dN_e:Eu_x$,
wobei x = 0,005 ~ 0,400, b + c = 12, und d + e = 16;

(d) Aluminatsystem-Leuchtpulver mit $Eu^{2+}$ als Aktivator, und

allgemeine chemische Zusammensetzungsformel: $(Sr,Ba)_{2-x}Al_2O_4:Eu_x$ oder $(Sr,Ba)_{4-x}Ali_4O_{25}:Eu_x$,
wobei x = 0,01 ~ 0,15.

9. Lichtquellenmodul (L1) nach Anspruch 1, wobei das rote Leuchtpulver oder das orange Leuchtpulver durch Mischen von einem oder mehreren der folgenden Leuchtpulver gebildet wird:

(a) rotes Nitridpulver mit einer 1113-Kristallstruktur mit $Eu^{2+}$ als Aktivator, und

allgemeine chemische Zusammensetzungsformel: $(M4)_{1-x}AlSiN_3:Eu_x$,
wobei M4 mindestens ein Element ausgewählt aus einer Gruppe bestehend aus Ca, Sr und Ba ist, wobei x = 0,005 ~ 0,300;

(b) rotes Nitridpulver mit einer 258-Kristallstruktur mit $Eu^{2+}$ als Aktivator, und

allgemeine chemische Zusammensetzungsformel: $(M5)_{2-x}Si_5N_8:Eu_x$,
wobei M5 mindestens ein Element ausgewählt aus einer Gruppe bestehend aus Ca, Sr, Ba und Mg ist, wobei x = 0,005 ~ 0,300;

(c) Stickoxid-Leuchtpulver (Zyklon α - SiALON) mit $Eu^{2+}$ als Aktivator, und allgemeine chemische Zusammensetzungsformel: $((M6)_{1-a})_xSi_bAl_cO_dN_e:Eu_a$, wobei M6 mindestens ein Element ausgewählt aus einer Gruppe bestehend aus Li, Na, K, Rb, Cs, Sr, Ba, Sc, Y, La und Gd ist, wobei x = 0,15 ~ 1,5, a = 0,005 ~ 0,300, b + c = 12, und d + e = 16;
(d) Silikat-Leuchtpulver mit $Eu^{2+}$ als Aktivator, und
allgemeine chemische Zusammensetzungsformel: $(Sr,Ba)_{3-x}Si_5O_5:Eu_x$.

10. Lichtquellenmodul (L1) nach Anspruch 1, wobei das Ppackungsteil (2) ferner ein Basismaterial (204) und einen Lichtdiffuser aufweist, wobei das Basismaterial (204) Kieselgel oder Harz ist, und wobei der Lichtdiffusor eines ausgewählt aus einer Gruppe bestehend aus Nano-Titandioxid, Nano-Aluminium und Nano-Siliziumoxid ist.

11. Lichtquellenmodul (L1) nach einem der Ansprüche 1-10, wobei auf dem CIE1931-Farbraum die Lichtfarbe des emittierten Lichts des Lichtquellenmoduls (L1) sich in einem viereckigen Bereich befindet, der von vier Eckpunkten D1 (0,3184; 0,3401), D2 (0,3203; 0,3189), D3 (0,3356; 0,3323) und D4 (0,3364; 0,3564) umschlossen ist.

12. Lichtquellenmodul (L1) nach Anspruch 11, wobei auf dem CIE1931-Farbraum die Lichtfarbe des emittierten Lichts des Lichtquellenmoduls (L1) sich in einem elliptischen Bereich befindet mit einem Mittelpunkt x0 = 0,3281, y0 = 0,3372, einer langen Achse a = 0,00223, einer kurzen Achse b = 0,00095, einem Neigungswinkel θ = 58,2°, und einer Standardabweichung der Farbanpassung SDCM = 5,0.

13. Lichtquellenmodul (L1) nach einem der Ansprüche 1-11, wobei, wenn das emittierte Licht des Lichtquellenmoduls (L1) eine Beleuchtungsstärke von 500 lux aufweist, ein zirkadianer Stimuluswert ≥ 0,45 ist.

14. Lichtquellenmodul (L1) nach einem der Ansprüche 1-11, wobei ein Farbwiedergabeindex CRI des emittierten Lichts des Lichtquellenmoduls (L1) ≥ 90,0 ist.

15. Beleuchtungsvorrichtung (D1), die das Lichtquellenmodul (L1) nach einem der Ansprüche 1 bis 14 aufweist.

**Revendications**

1. Module de source de lumière (L1), comprenant un premier élément electroluminescent (1) et une partie d'encapsulation (2) recouvrant le premier élément electroluminescent (1),

le premier élément electroluminescent (1) émet une première lumière de couleur avec une longueur d'onde de pic de 435 à 465 nm ;
la partie d'encapsulation (2) comprend :

un premier corps lumineux supplémentaire (201) qui est agencé pour recevoir une partie de la lumière émise par le premier élément émetteur de lumière (1) et la convertir en une lumière de deuxième couleur avec une longueur d'onde de pic de 485 à 515 nm ;
un deuxième corps lumineux supplémentaire (202) qui est agencé pour recevoir une partie de la lumière émise par le premier élément émetteur de lumière (1) et la convertir en une lumière de troisième couleur avec une longueur d'onde de pic de 520 à 580 nm ;
un troisième corps lumineux supplémentaire (203) qui est agencé pour recevoir une partie de la lumière émise par le premier élément émetteur de lumière (1) et la convertir en une lumière de quatrième couleur avec une longueur d'onde de pic de 615 à 655 nm,
la première lumière de couleur, la deuxième lumière de couleur, la troisième lumière de couleur et la quatrième lumière de couleur sont mélangées pour former la lumière émise par le module de source de lumière (L1), la lumière émise étant une lumière blanche froide, c'est-à-dire que dans l'espace colorimétrique CIE1931, la lumière émise se situe dans un intervalle délimité par des points ayant une température de couleur corrélée de 5750 ± 400 K et des distances par rapport à la trajectoire du corps noir duv = -0,006 à 0,006,
un spectre de la lumière émise a des caractéristiques suivantes obtenues en sélectionnant le rapport pondéral de poudre approprié :

la définition de l'énergie spectrale du spectre de la lumière émise dans une plage de lumière visible, c'est-à-dire, une plage de longueurs d'onde [380 à 780 nm] en tant que totalité de l'énergie spectrale de la lumière émise ;
une énergie spectrale dans une plage de longueurs d'onde [380 à 470 nm] représente 12,0 à 32,0 % de la totalité de l'énergie spectrale ;
une énergie spectrale dans une plage de longueurs d'onde [470 à 560 nm] représente 25,0 à 45,0 % de la totalité de l'énergie spectrale ;
une énergie spectrale dans une plage de longueurs d'onde [560 à 780 nm] représente 36,0 à 56,0 % de la totalité de l'énergie spectrale ; et
une énergie spectrale dans une plage de longueurs d'onde [470 à 520 nm] représente 14,0 à 34,0 % de la totalité de l'énergie spectrale ;
dans lequel le premier élément electroluminescent (1) est une DEL bleue émettant de la lumière avec une longueur d'onde de pic de 435 à 465 nm ; le premier corps lumineux supplémentaire (201) est une poudre fluorescente bleu-vert avec une longueur d'onde de pic de 485 à 515 nm et une demi-largeur de 25 à 65 nm ; le deuxième corps lumineux supplémentaire (202) est une poudre fluorescente jaune et/ou une poudre fluorescente verte avec une longueur d'onde de pic de 520 à 580 nm et une demi-largeur de 60 à 115 nm ; le troisième corps lumineux supplémentaire (203) est une poudre fluorescente rouge ou une poudre fluorescente orange avec une longueur d'onde de pic de 615 à 655 nm et une demi-largeur de 80 à 120 nm, et définissant un poids total du premier corps lumineux supplémentaire (201), du deuxième corps lumineux supplémentaire (202) et du troisième corps lumineux supplémentaire (203) pour être un poids total de poudre fluorescente ;

dans lequel un rapport du premier corps lumineux supplémentaire (201) dans le poids total de poudre fluorescente varie de 20,0 à 55,0 % ;

dans lequel un rapport du deuxième corps lumineux supplémentaire (202) dans le poids total de poudre fluorescente varie de 22,0 à 52,0 % ; et

dans lequel un rapport du troisième corps lumineux supplémentaire (203) dans le poids total de poudre fluorescente varie de 7,0 à 36,0 %.

2. Module de source de lumière (L1) selon la revendication 1, dans lequel, dans le spectre de la lumière émise :

l'énergie spectrale dans la plage de longueurs d'onde [380 à 470 nm] représente 17,0 à 27,0 % de la totalité de l'énergie spectrale ;

l'énergie spectrale dans la plage de longueurs d'onde [470 à 560 nm] représente 27,0 à 37,0 % de la totalité de l'énergie spectrale ;

l'énergie spectrale dans la plage de longueurs d'onde [560 à 780 nm] représente 40,0 à 50,0 % de la totalité de l'énergie spectrale, et

l'énergie spectrale dans la plage de longueurs d'onde [470 à 520 nm] représente 18,0 à 28,0 % de la totalité de l'énergie spectrale.

3. Module de source de lumière (L1) selon la revendication 1, dans lequel le spectre de la lumière émise est distribué de manière continue dans la plage de lumière visible de 380 à 780 nm, et comprend trois pics et deux pics-creux, dans lequel

un premier pic (P1) se situe dans une plage de longueurs d'onde de 435 à 465 nm ;

un deuxième pic (P2) se situe dans une plage de longueurs d'onde de 485 à 525 nm, et un rapport entre une intensité spectrale du deuxième pic et l'intensité spectrale du premier pic varie de 45,0 à 85,0 % ;

un premier pic-creux (V1) se situe entre le premier pic (P1) et le deuxième pic (P2), et un rapport entre une intensité spectrale du premier pic-creux (V1) et l'intensité spectrale du premier pic (P1) est supérieur ou égal à 25,0 % ;

un troisième pic (P3) se situe dans une plage de longueurs d'onde de 595 à 645 nm, et un rapport entre une intensité spectrale du troisième pic (P3) et l'intensité spectrale du premier pic (P1) varie de 40,0 à 70,0 % ; et

un deuxième pic-creux (V2) se situe entre le deuxième pic (P2) et le troisième pic (P3), et un rapport entre l'intensité spectrale du deuxième pic-creux (V2) et l'intensité spectrale du premier pic (P1) varie de 30,0 à 60,0 %.

4. Module de source de lumière (L1) selon la revendication 3, dans lequel, dans le spectre de la lumière émise :

le rapport entre l'intensité spectrale du deuxième pic (P2) et l'intensité spectrale du premier pic (P1) varie de 55,0 à 75,0 % ;

le rapport entre l'intensité spectrale du troisième pic (P3) et l'intensité spectrale du premier pic (P1) varie de 42,0 à 60,0 % ; et

le rapport entre l'intensité spectrale deuxième pic-creux (V2) et l'intensité spectrale du premier pic (P1) varie de 35,0 à 50,0 %.

5. Module de source de lumière (L1) selon la revendication 3, dans lequel, dans le spectre de la lumière émise : le rapport entre l'intensité spectrale du troisième pic (P3) et l'intensité spectrale du deuxième pic (P2) varie de 75 à 105 %.

6. Module de source de lumière (L1) selon la revendication 5, dans lequel, dans le spectre de la lumière émise : le rapport entre l'intensité spectrale du troisième pic (P3) et l'intensité spectrale du deuxième pic (P2) varie de 80 à 100 %.

7. Module de source de lumière (L1) selon la revendication 1, dans lequel la poudre fluorescente bleu-vert est formée en mélangeant une ou plusieurs parmi les poudres fluorescentes suivantes :

(a) oxyde d'azote avec $Eu^{2+}$ en tant qu'activateur, et

formule chimique générale de la composition : $(Ba,Ca)_{1-x}Si_2N_2O_2:Eu_x$,
où x = 0,005 - 0,200 ;

(b) poudre fluorescente de grenat dopé au Ga avec $Eu^{2+}$ en tant qu'activateur, et

formule chimique générale de la composition : Ga-LuAG:Eu ;

(c) poudre fluorescente de silicate, avec $Eu^{2+}$ en tant qu'activateur, et formule chimique générale de la composition : $Ba_2SiO_4$:Eu.

8. Module de source de lumière (L1) selon la revendication 1, dans lequel la poudre fluorescente jaune/poudre fluorescente verte est formée par le mélange d'une ou de plusieurs parmi les poudres fluorescentes suivantes :

(a) poudre fluorescente de structure grenat avec $Ce^{3+}$ en tant qu'activateur, et

formule chimique générale de la composition : $(M1)_{3-x}(M2)_5O_{12}$:$Ce_x$,
où M1 représente au moins un élément choisi dans un groupe constitué de Y, Lu, Gd et La, M2 est au moins un élément choisi dans un groupe constitué de Al et Ga, et x = 0,005 - 0,200 ;

(b) poudre fluorescente de système silicate avec $Eu^{2+}$ en tant qu'activateur, et

formule chimique générale de la composition : $(M3)_{2-x}SiO_4$:$Eu_x$ ou $(Ba,Ca,Sr)_{2-x}(Mg,Zn)Si_2O_7$:$Eu_x$,
où M3 représente au moins un élément choisi dans un groupe constitué de Mg, Sr, Ca et Ba, et x = 0,01 - 0,20 ;

(c) poudre fluorescente d'oxyde d'azote (Cylon $\beta$-SiAlON) avec $Eu^{2+}$ en tant qu'activateur, et

formule chimique générale de la composition : $Si_bAl_cO_dN_e$:$Eu_x$,
où x = 0,005 - 0,400, b + c = 12, et d + e = 16;

(d) poudre fluorescente de système aluminate, avec $Eu^{2+}$ en tant qu'activateur, et

formule chimique générale de la composition : $(Sr,Ba)_{2-x}Al_2O_4$:$Eu_x$
ou $(Sr,Ba)_{4-x}Al_{14}O_{25}$:$Eu_x$,
où x = 0,01 - 0,15.

9. Module de source de lumière (L1) selon la revendication 1, dans lequel la poudre fluorescente rouge ou la poudre fluorescente orange est formée par le mélange d'une ou de plusieurs parmi les poudres fluorescentes suivantes :

(a) poudre rouge de nitrure ayant une structure cristalline 1113 avec $Eu^{2+}$ comme activateur, et

formule chimique générale de la composition : $(M4)_{1-x}AlSiN_3$:$Eu_x$,
où M4 représente au moins un élément choisi dans un groupe constitué de Ca, Sr et Ba, x = 0,005 ~ 0,300 ;

(b) poudre rouge de nitrure ayant une structure cristalline 258 avec $Eu^{2+}$ comme activateur, et

formule chimique générale de la composition : $(M5)_{2-x}Si_5N_8$:$Eu_x$,
où M5 représente au moins un élément choisi dans un groupe constitué de Ca, Sr, Ba et Mg, x = 0,005 ~ 0,300 ;

(c) poudre fluorescente d'oxyde d'azote (Cylon $\alpha$- SiALON) avec $Eu^{2+}$ en tant qu'activateur, et

formule chimique générale de la composition : $((M6)_{1-a})_xSi_bAl_cO_dN_e$:$Eu_a$,
où M6 représente au moins un élément choisi dans un groupe constitué de Li, Na, K, Rb, Cs, Sr, Ba, Sc, Y, La et Gd, x = 0,15 ~ 1,5, a = 0,005 - 0,300, b + c = 12, et d + e = 16 ;

(d) poudre fluorescente de silicate avec $Eu^{2+}$ en tant qu'activateur, et formule chimique générale de la composition : $(Sr,Ba)_{3-x}Si_5O_5$:$Eu_x$.

10. Module de source de lumière (L1) selon la revendication 1, dans lequel la partie d'encapsulation (2) comprend en outre un matériau de base (204) et un diffuseur de lumière, le matériau de base (204) étant un gel de silice ou une résine, et le diffuseur de lumière étant choisi dans un groupe constitué de nano oxyde de titane, de nano alumine et de nano oxyde de silicium.

**11.** Module de source de lumière (L1) selon l'une quelconque des revendications 1 à 10, dans lequel, sur l'espace de couleur CIE1931, la lumière de couleur de la lumière émise du module de source de lumière (L1) se situe dans une région quadrilatérale entourée par quatre sommets D1 (0.3184,0.3401), D2 (0.3203,0.3189), D3 (0.3356,0.3323) et D4 (0.3364,0.3564).

**12.** Module de source de lumière (L1) selon la revendication 11, dans lequel, sur l'espace de couleur CIE1931, la lumière de couleur de la lumière émise du module de source de lumière (L1) se situe dans une plage elliptique avec un point central x0 = 0,3281, y0 = 0,3372, un axe long a = 0,00223, un axe court b = 0,00095, un angle d'inclinaison $\theta$= 58,2°, et une correspondance de couleur d'écart type SDCM = 5,0.

**13.** Module de source de lumière (L1) selon l'une quelconque des revendications 1 à 11, dans lequel, dans un cas où la lumière émise du module de source de lumière (L1) a un éclairement de 500 lux, une valeur de stimulus circadien CS est $\geq$ 0,45.

**14.** Module de source de lumière (L1) selon l'une des revendications 1 à 11, dans lequel l'indice de rendu des couleurs IRC de la lumière émise du module de source de lumière (L1) est $\geq$ 90,0.

**15.** Dispositif d'éclairage (D1) comprenant le module de source de lumière (L1) selon l'une quelconque des revendications 1 à 14.

FIG. 1

FIG. 2

FIG. 3

FIG. 4

FIG. 5

FIG. 6

FIG. 7

FIG. 8

FIG. 9

FIG. 10

FIG. 11

FIG. 12

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- DE 102014117771 A1
- US 20190058092 A1
- US 20190103522 A1